# FASCICULE DE BREVET EUROPEEN

(11) **EP 1 595 001 B1**
(45) Date de publication et mention de la délivrance du brevet: **02.05.2007**
(21) Numéro de dépôt: 04710908.7
(22) Date de dépôt: 13.02.2004
(51) Int. Cl.: C23C 14/02, B05D 7/00

(54) **PROCEDE DE REVETEMENT D UNE SURFACE**
OBERFLÄCHENBESCHICHTUNGSVERFAHREN
SURFACE-COATING METHOD

(30) Priorité: 17.02.2003 FR 0301874
(43) Date de publication de la demande: 16.11.2005
(73) Titulaire: COMMISSARIAT A L'ENERGIE ATOMIQUE, 75015 Paris (FR)
(72) Inventeur: VIEL, Pascal, F-92190 Meudon (FR); AMEUR, Sami, 4020 Sousse (TN); BUREAU, Christophe, F-92150 Suresnes (FR)
(74) Mandataire: Poulin, Gérard
(86) Numéro de dépôt international: PCT/FR2004/050058
(87) Numéro de publication internationale: WO 2004/074537

(56) Documents cités:
- WO-A-00/24527
- WO-A-03/008660
- WO-A-03/018212
- US-A- 5 350 323
- US-A1- 2002 168 528
- US-B1- 6 517 858

## Description

### Domaine technique

L'invention concerne le dépôt ou la fixation de matériaux sur des surfaces.

Elle se rapporte en particulier à procédé de revêtement d'une surface, notamment à un procédé de dépôt très adhérent d'un matériau sur une surface.

Le procédé de l'invention a pour objectif de permettre un dépôt adhérent de tout type de matériaux sur tout type de surfaces.

### Art antérieur

De très nombreuses techniques ont été décrites à ce jour concernant le revêtement de surfaces en général, et en particulier concernant la fixation de matériaux sur des surfaces conductrices ou semi-conductrices de l'électricité. Seront considérés ci-dessous, dans cet ordre, le dépôt adhérent de polymères sur des surfaces conductrices ou semi-conductrices de l'électricité, le dépôt adhérent de métaux sur des surfaces conductrices ou semi-conductrices de l'électricité, et le dépôt adhérent d'isolants ioniques sur des surfaces conductrices ou semi-conductrices de l'électricité, afin de mettre en évidence les nombreux avantages de la présente invention.

L'opération par laquelle on parvient à fixer une molécule d'intérêt, par exemple une molécule ayant des propriétés particulières, sur une surface de façon à ce qu'elle y conserve tout ou partie de ses propriétés est appelée fonctionnalisation. La fonctionnalisation d'une surface suppose que l'on dispose de la molécule d'intérêt à fixer et d'un procédé adéquat pour fixer ladite molécule sur la surface. La molécule d'intérêt étant le plus souvent une molécule organique ou organométallique, le procédé généralement utilisé consiste à tirer partie de la très large bibliothèque de réactions de la chimie organique en essayant de trouver des groupements fonctionnels, respectivement sur la surface et sur la molécule d'intérêt, qui soient compatibles, c'est-à-dire qui puissent facilement - et si possible rapidement - réagir entre eux.

Lorsque l'on dispose par exemple d'une surface possédant des groupements hydroxyles -OH ou amine -NH, on peut la fonctionnaliser en dotant la molécule d'intérêt par exemple de groupements isocyanates, siloxanes, chlorures d'acide, etc. Lorsque la molécule d'intérêt ne dispose pas de groupements fonctionnels directement compatibles avec ceux de la surface, on peut pré-fonctionnaliser cette surface avec une molécule organique intermédiaire bifonctionnelle, dont l'un des groupements fonctionnels est compatible avec ceux de la surface, et l'autre avec ceux de la molécule que l'on veut fixer. On dit parfois que la molécule intermédiaire est un primaire d'adhésion comme le décrit le document **[1]**.

De ce point de vue, on constate que la fonctionnalisation d'une surface n'est qu'un cas particulier de réactions de la chimie organique, où l'un des deux réactifs est une surface, plutôt qu'une molécule en solution. Certes la cinétique associée aux réactions hétérogènes entre une solution et une surface est sensiblement différente de la réaction analogue en phase homogène, mais les mécanismes réactionnels sont sur le principe identiques.

Dans certains cas, on active la surface en la pré-traitant de façon à y créer des groupements fonctionnels ayant une réactivité supérieure, de façon à obtenir une réaction plus rapide. Il peut notamment s'agir de groupements fonctionnels instables, formés de façon transitoire, comme par exemple des radicaux formés par oxydation brutale de la surface, soit par voie chimique, soit par voie d'irradiation. Dans ces techniques, on modifie soit la surface soit la molécule d'intérêt de façon à ce que - une fois modifiée(s) - l'accrochage entre les deux entités se ramène à une réaction connue par ailleurs dans la bibliothèque des réactions de la chimie organique.

Malheureusement ces méthodes nécessitent des pré-traitements relativement complexes et coûteux, tels que l'utilisation d'installations sous vide pour les méthodes plasma telles que le dépôt chimique en phase vapeur (CVD) (« chemical Vapor Deposition » en anglais), la technique de dépôt chimique en phase vapeur assisté par plasma (PACVD) (« Plasma Assisted Chemical Vapor Deposition » en anglais), l'irradiation, etc., qui ne préservent d'ailleurs pas forcément l'intégrité chimique des précurseurs.

De plus, on observe que ces méthodes ne sont réellement opérationnelles que dans la mesure où la surface à traiter a une structure électronique analogue à celle d'un isolant : dans le langage des physiciens, on peut dire qu'il faut que la surface possède des états localisés. Dans celui des chimistes, qu'elle possède des groupements fonctionnels. Sur les métaux par exemple, les traitements par dépôt réactif (CVD, PACVD, plasma, etc.) permettent un meilleur accrochage du dépôt sur la couche d'oxyde ou tout au moins sur une couche de ségrégation sensiblement isolante.

Cependant, lorsque la surface est un conducteur ou un semi-conducteur non dopé, de tels états localisés n'existent pas : les états électroniques de la surface sont des états délocalisés. En d'autres termes, la notion de « groupement fonctionnel » au sens de la chimie organique n'a pas de sens, et il est ainsi impossible d'utiliser la bibliothèque des réactions de la chimie organique pour fixer une molécule organique d'intérêt sur une surface.

Deux exceptions notables existent : ce sont les réactions chimiques spontanées des thiols décrites notamment dans le document **[2],** et des isonitriles décrites par exemple dans le document **[3]** sur les surfaces métalliques, et notamment sur les surfaces d'or.

Mais ces réactions ne sont pas exploitables dans toutes les situations. En effet, les thiols, par exemple, donnent lieu à des liaisons soufre/métal fragiles. Ces liaisons sont rompues, par exemple, lorsque le métal est ultérieurement polarisé cathodiquement ou anodiquement, pour former respectivement des thiolates et des sulfonates, qui désorbent.

Le moyen le plus employé actuellement pour réaliser la fixation de molécules organiques sur des surfaces conductrices ou semi-conductrices de l'électricité est de contourner la difficulté en se ramenant à un problème connu. Il s'agit de former sur ces surfaces, au préalable, des groupements hydroxyles -OH, en assurant la promotion d'une couche d'oxyde totalement ou partiellement hydratée sur le métal. Sur le graphite, qui ne possède pas d'oxyde solide, l'anodisation produit cependant des groupements hydroxyles qui sont exploitables. Lorsque l'on a pu former des groupements hydroxyles sur la surface, on est ramené à une surface qui possède des états électroniques de surface localisés, c'est-à-dire des groupements fonctionnels, et on est ramené à un problème connu. En particulier, il est alors possible d'appliquer tous les procédés de fonctionnalisation qui ont été listés plus haut pour les surfaces d'isolants.

Cependant, outre le fait qu'il est impossible de former une couche d'oxyde sur l'or ainsi que sur de nombreux métaux nobles, la solidité de l'interface fabriquée entre la molécule organique d'intérêt et la surface métallique dépend de la couche d'oxyde. Or certains oxydes, en particulier lorsqu'ils sont non stoechiométriques, ne sont pas couvrants voire non adhérents. De plus, cette voie nécessite au moins deux ou trois étapes pour aboutir à la fixation d'une molécule d'intérêt, puisqu'il faut d'abord construire la couche d'oxyde avant d'accrocher la molécule elle-même (deux étapes), ou bien avant d'accrocher un primaire d'adhésion qui permettra l'accrochage de la molécule d'intérêt (trois étapes).

Il est également possible de fixer des fragments organiques sur des surfaces conductrices et semi-conductrices par voie électrochimique. Ainsi, le procédé décrit par exemple dans le document **[4]** permet de fixer sur les surfaces conductrices des groupements fonctionnels organiques. Il s'agit d'un procédé par lequel une surface conductrice est mise sous potentiel (cathodique) dans une solution contenant des sels d'aryl diazonium, fonctionnalisés par le groupement fonctionnel que l'on veut fixer sur la surface. Or, les sels d'aryl diazonium sont fabriqués à partir d'une amine aromatique, grâce à une réaction de diazotisation utilisant par exemple du nitrite de sodium en milieu chlorhydrique. Cette étape nécessite un pH très bas, et n'est donc pas compatible avec tous les groupements fonctionnels. On sait par exemple qu'il est impossible de diazotiser une amine aromatique porteuse d'un groupement succinimide, utile pour fixer une molécule d'intérêt portant des groupements hydroxyde ou amine, ou d'un groupement amine. De plus, on observe de façon générale que les solutions préparées à partir de sels d'aryl diazonium sont instables à court terme, notamment du fait que ces sels sont thermo- et photo-clivables : cela limite donc leur applicabilité pratique.

Cependant, lorsque aucun groupement fonctionnel n'est compatible à la fois avec ceux de la molécule d'intérêt et avec la réaction de diazotisation, l'utilisation du procédé de greffage des sels de diazonium nécessite donc de passer par une étape intermédiaire où la couche électro-greffée est fonctionnalisée par un primaire d'adhésion bi-fonctionnel, dont l'un des groupements au moins est compatible avec les groupements fonctionnels de la molécule d'intérêt.

De plus, ce procédé ne permet pas, dans la pratique, de réaliser des couches épaisses, ce qui conduit à un nombre de groupements fonctionnels greffés relativement faible, et très proches de la surface. Les groupements fonctionnels qui ont été greffés sont globalement modérément accessibles pour des réactions de fonctionnalisation ultérieure avec une molécule organique. La conséquence pratique la plus directe de cette remarque est que les réactions de post-fonctionnalisation sur les surfaces conductrices recouvertes d'une couche organique selon ce procédé sont lentes.

L'électro-greffage de polymères, tel qu'il est décrit par exemple dans le document **[5],** permet d'initier la croissance de chaînes de polymères, notamment vinyliques, grâce à une surface métallique polarisée, qui sert d'amorceur. A la différence du procédé précédent, l'électro-greffage de polymères permet l'obtention de films d'épaisseur ajustable. L'expérience acquise dans le domaine montre que la gamme comprise entre 2 nm et 1 µm est accessible à ce type de procédé.

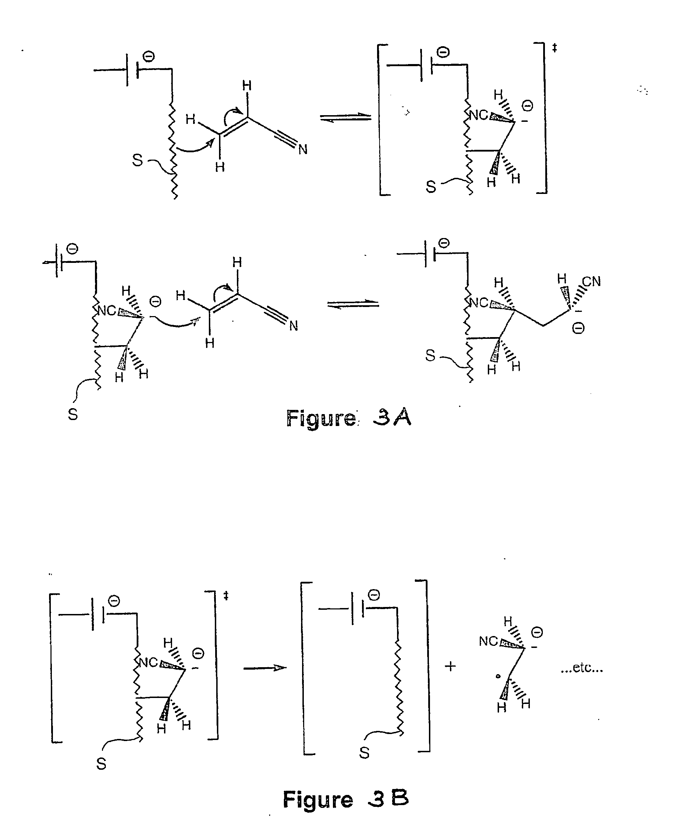

Une des particularités de l'électro-greffage de polymères est qu'il conduit à la formation de véritables liens covalents carbone/métal entre le polymère et la surface. Ce résultat, qui est une conséquence directe du mécanisme réactionnel représenté sur la figure 3 annexée, est une voie très intéressante de fixation solide de fragments organiques sur des surfaces conductrices et semi-conductrices de l'électricité.

Cependant, le procédé étant basé sur la synthèse in situ du polymère sur la surface, des restrictions importantes apparaissent sur la nature des monomères précurseurs éligibles, et donc des types de polymères qui peuvent être déposés sur des surfaces conductrices ou semi-conductrices par ce procédé :
- Il apparaît que seuls les monomères vinyliques et les molécules cycliques clivables par attaque nucléophile ou électrophile comme les lactones soient compatibles avec ces mécanismes, du fait que ce sont les seules molécules pouvant polymériser par croissance chimique ionique.
- Parmi les monomères ci-dessus, seuls ceux ayant des groupements électro-attracteurs ou électro-donneurs sont à même d'activer suffisamment les précurseurs pour que la croissance soit effective.
- La croissance étant relativement gênée par la proximité de la surface, on observe en général que l'électro-greffage ne conduit qu'à des chaînes de polymère assez courtes, ce qui exclut d'avoir recours à ce procédé pour fixer des polymères de structures pourtant éligibles mais de haut poids moléculaire.

Du fait de ces restrictions, l'électro-greffage ne peut donc malheureusement pas offrir de solution systématique pour la fixation de n'importe quel type de matériau polymère sur une surface.

Pourtant, l'électro-greffage constitue un biais intéressant pour résoudre le problème de l'interface organique/conducteur, ce qui a conduit par exemple à les utiliser comme matrice de croissance de films mixtes films-électro-greffés/polymères-conducteurs, de façon à tirer simultanément parti de la forte adhésion des chaînes électro-greffées sur métal, et des propriétés anti-corrosion de certains polymères conducteurs comme le polypyrrole, en eux-mêmes peu adhérents sur les substrats sur lesquels ils ont été synthétisés comme le décrit le document **[6]** de la liste de références annexée. Les revêtements formés par ces auteurs sont des revêtements composites, où le polymère conducteur est enfoui à l'interface métal/organique pour assurer sa protection anti-corrosion, et est, en quelque sorte, « encapsulé » par le polymère électro-greffé, comme le révèle l'analyse de surface en spectroscopie de photoélectrons X (XPS).

Un autre exemple de procédé est l'électrodéposition de polymères, ou cataphorèse, qui est un procédé électrochimique permettant d'attirer, par interaction essentiellement électrostatique, un polymère chargé (poly-électrolyte) présent dans une solution sur une surface conductrice ou semi-conductrice de l'électricité tel que le décrit le document **[7]** de la liste de références annexée. Ce procédé permet d'obtenir des revêtements relativement adhérents sur les surfaces conductrices ou semi-conductrices de l'électricité, même si l'absence de liaisons polymère/métal conduit à des interfaces sensibles en conditions d'usage. Il est toutefois restreint à des polymères chargés, et procède par réaction électro-suivie, où l'épaisseur est étroitement dépendante du courant électrique local. On observe ainsi en général des dépôts assez fortement inhomogènes aux faibles épaisseurs, un effet nivelant n'étant obtenu que pour des couches épaisses typiquement de plusieurs microns voire au-delà.

A l'instar de ce qui a été rappelé pour le dépôt de polymères, on distingue principalement deux grandes voies pour le dépôt des métaux sur les surfaces conductrices et semi-conductrices de l'électricité :
- La voie électrochimique, ou électrodéposition (« electroplating » ou « Electro-Chemical Deposition ou ECD » en anglais) selon laquelle on réalise schématiquement la réduction d'une solution contenant des sels du métal que l'on souhaite déposer sur la surface d'intérêt, utilisée comme électrode de travail. L'électrolyse de cette solution permet le dépôt du métal d'intérêt sur la surface, pour autant que le potentiel de réduction nécessaire soit compatible avec le solvant et l'électrolyte support choisis. On observe cependant en général que divers additifs tels que des tensioactifs, des brillanteurs, etc. sont nécessaires pour obtenir un dépôt homogène de bonne qualité. En outre, même avec ces additifs, ce procédé construit des interfaces abruptes donc fragiles, sauf à opérer un recuit à haute température pour provoquer la fusion à l'interface. De plus, électrodéposition de métaux sur des surfaces semi-conductrices, notamment lorsqu'elles sont ouvragées et lorsqu'un dépôt conforme à l'ouvrage est demandé, reste impossible, notamment parce que la réaction électrodéposition est une réaction électro-suivie, et donc fortement sensible à la topologie de chute ohmique. Ce problème s'est présenté dans le procédé Damascene utilisé en microélectronique pour la réalisation de réseaux interconnectés de cuivre décrit par exemple dans le document **[8]** de la liste de références annexée : on dépose des pistes de cuivre dans des gravures, de plus en plus étroites, de l'ordre d'une centaine de nanomètres aujourd'hui, tapissées de couches barrières constituées par des matériaux semi-conducteurs comme le nitrure de titane ou le nitrure de tantale, dont la résistivité est de quelques centaines de micro-ohms centimètre. Malgré cette résistivité modérée, les problèmes d'uniformité de dépôt ne peuvent être résolus qu'au prix de la mise en place d'une sous-couche de cuivre (couche de germination ou « seed-layer » en anglais) très fine par CVD ou PVD (« Physical Vapor Deposition » en anglais) pour améliorer l'homogénéité du dépôt de cuivre par électrodéposition.
- Les procédés par projection, comme la CVD, la PVD et les méthodes apparentées telles que PACVD, ALCVD (« Atomic Layer CVD » en anglais). Comme indiqué ci-dessus, ces méthodes sont utilisées pour réaliser une couche de germination pour le dépôt de cuivre par électrodéposition dans le procédé Damascene. Cependant, l'interface construite par CVD ou par PVD entre le cuivre du seed-layer et la surface de semi-conducteur appelée couche barrière, est abrupte. La très faible affinité du cuivre pour ces matériaux barrières engendre des problèmes d'adhésion à l'interface cuivre/barrière, notamment aux très faibles épaisseurs (< 50 nm). Ces problèmes d'adhésion sont sources de contraintes mécaniques au moment des recuits, de ruptures d'interfaces et donc de baisses de rendement dans le procédé. Ces problèmes constituent, encore aujourd'hui, une préoccupation et un enjeu majeurs pour le succès du procédé Damascene, en particulier aux très fines gravures de 0,1 µm et en deçà, et nécessitent des moyens complémentaires pour renforcer l'interface entre le « seed-layer » et les matériaux barrières semi-conducteurs.

Pour ce qui concerne le dépôt de solides isolants, il s'agit de matériaux qui ne sont pas des polymères tels que ceux décrits plus haut. On considère en effet ici les solides ioniques, comme les sels insolubles tels que les halogénures d'argent, les hydroxyapatites, les carbonates d'alcalins ou d'alcalino-terreux, les tartrates d'alcalins ou d'alcalino-terreux, les citrates d'alcalins ou d'alcalino-terreux, les oxalates d'alcalins ou d'alcalino-terreux, etc.

Par nature, ces matériaux ont une structure électronique très différente de celle des matériaux conducteurs et semi-conducteurs de l'électricité, si bien qu'il est difficilement envisageable de promouvoir des liaisons à l'interface isolants ioniques/conducteurs ou isolants ioniques/semi-conducteurs. L'interface entre ces sels précipités et des surfaces conductrices ou semi-conductrices de l'électricité reste donc abrupte, et pour le moins non contrôlée.

On sait qu'il serait intéressant, par exemple, de réaliser le dépôt adhérent et reproductible de revêtements, par exemple d'hydroxyapatites calciques sur des surfaces de titane d'implants médicaux, et notamment de prothèses de hanches ou encore d'implants dentaires, d'une part pour réaliser une couche barrière et empêcher la corrosion du métal et la diffusion d'ions métalliques - sources d'inflammations - et d'autre part pour offrir, sur la surface de la prothèse, un terrain suffisamment biomimétique pour favoriser l'accrochage et la croissance de cellules osseuses (par exemple les ostéoblastes et les ostéoclastes) et la recolonisation de l'objet implanté par les tissus avoisinants. On connaît la nécessité d'un accrochage performant du solide sur la surface du métal, en particulier en conditions d'utilisation lorsque la prothèse est elle-même soumise à des sollicitations mécaniques comme c'est le cas dans les prothèses de hanche, par exemple.

Or, il est fréquemment observé qu'en conditions d'utilisation, les parties céramiques d'une prothèse de hanche viennent à s'effriter, relarguant localement des micro et nanoparticules sources d'inflammations locales, qui peuvent nécessiter une intervention pour remplacement.

Comme dans les situations précédentes, on réalise aujourd'hui :
- le dépôt de phosphate de calcium par projection plasma sur des implants métalliques, par exemple queue de prothèse de hanche ;
- la formation de couches d'apatite carbonatée par immersion dans un fluide simulant les propriétés des liquides interstitiels (« Simulated Body Fluids » en anglais).

Ces méthodes sont essentiellement empruntées au traitement de surface traditionnel, et se caractérisent par la précipitation du solide sur la surface, éventuellement pré-traitée. Pour les motifs de différences de structures électroniques rappelés plus haut, le renforcement des interfaces entre ces solides et une surface conductrice ou semi-conductrice reste problématique, et les inconvénients précités ne sont pas résolus.

Il apparaît donc un réel besoin de nouvelles techniques de revêtement de surfaces en général, qui répondent aux nombreux problèmes et inconvénients précités des techniques de l'art antérieur.

### Exposé de l'invention

Le but de la présente invention est précisément de fournir un procédé qui répond, entre autres, à l'ensemble des besoins indiqués plus haut, qui satisfait aux critères et exigences mentionnés ci-dessus, qui ne présente pas les inconvénients, limitations, défauts et désavantages des procédés de l'art antérieur, et qui surmonte les problèmes des procédés de l'art antérieur liés, en particulier, à la nature de la surface et à la nature du revêtement qui doit revêtir ladite surface.

Les matériaux répertoriés ci-dessus, à savoir les polymères et macromolécules organiques, les solides qui peuvent être électrodéposés et en particulier les métaux, et enfin les solides déposables par précipitation ou par gravité ont des structures et des comportements très différents. C'est un objectif de la présente invention que de proposer un procédé pourtant commun qui permet de les fixer solidement sur une surface pour les y accrocher.

Le procédé de la présente invention est un procédé de revêtement d'une surface par un premier et un deuxième matériaux comprenant les étapes suivantes :
- disposer sur ladite surface le premier matériau,
- insérer au sein du premier matériau, un précurseur du deuxième matériau, en même temps que ou après l'étape consistant à disposer sur ladite surface ledit premier matériau,
- transformer ledit précurseur du deuxième matériau inséré au sein du premier matériau en ledit deuxième matériau de manière à ce que ce deuxième matériau se forme sur ladite surface à revêtir et au sein dudit premier matériau disposé sur ladite surface.

Le procédé de l'invention est applicable à tout type de surface, par exemple à des surfaces telles que celles citées ci-dessus dans la partie art antérieur.

Selon l'invention, la surface est, de manière générale, une surface d'un substrat sur laquelle un revêtement doit être déposé, ceci afin que le substrat concerné puisse être utilisé dans l'application à laquelle il est destiné, par exemple pour le protéger, pour protéger l'environnement dans lequel il est utilisé, pour le fonctionnaliser, etc. il peut s'agir d'une surface isolante, conductrice ou semi-conductrice. Il peut s'agir par exemple d'une surface minérale, par exemple métallique ou céramique ; d'une surface organique, par exemple polymérique. Ces surfaces seront appelées également « surface à revêtir » dans la présente. De nombreux exemples d'application sont donnés ci-dessous et d'autres encore apparaîtront à l'homme du métier.

Le procédé de la présente invention permet notamment d'obtenir un dépôt très adhérent d'un matériau, appelé ci-après « matériau d'intérêt », qui peut être le premier ou le deuxième matériaux au sens de la présente invention, sur une surface alors qu'en utilisant un procédé de l'art antérieur, ledit matériau d'intérêt n'adhère pas ou peu sur ladite surface. Plus particulièrement, elle permet de réaliser le dépôt adhérent d'un matériau d'intérêt sur une surface en combinant ce dépôt avec celui d'un autre matériau, appelé aussi matériau complémentaire. Au sens de la présente invention, si le matériau d'intérêt est le premier matériau, le matériau complémentaire est alors le deuxième matériau et inversement.

En effet, les matériaux qui peuvent être déposés de façon très adhérente sur des surfaces, notamment sur des surfaces conductrices ou semi-conductrices, selon la présente invention peuvent être répartis en deux catégories, suivant l'ordre de dépôt sur la surface.

La catégorie du premier matériau au sens de la présente invention, appelé ci-dessous « matériau marcottable » ou « matériau d'armature » suivant l'application qui est faite de la présente invention. Il peut s'agir par exemple de tout polymère ou de toute macromolécule organique connue de l'homme du métier permettant la mise en oeuvre de la présente invention. Il s'agit avantageusement de matériaux organiques pouvant être déposés par tout procédé permettant d'obtenir un dépôt, de préférence sous la forme d'un film, dudit matériau sur la surface à revêtir. Selon l'invention, le premier matériau est un matériau qui peut être avantageusement disposé sur la surface par une technique choisie parmi la centrifugation (« spin coating » ou « spin-on »), la pulvérisation, le trempage (« dip coating »), l'électro-polymérisation, l'électro-greffage, etc. On peut citer par exemple les polymères du pyrrole, de l'aniline, du thiophène, de l'éthylène dioxythiophène (EDOT), de l'éthylène diamine, des phénols, etc., ainsi que leurs dérivés. Ces polymères conviennent par exemple pour l'électropolymérisation. On peut citer par exemple aussi les polymères obtenus à partir des monomères vinyliques activés, cycliques clivables par attaque nucléophile ou électrophile. Ces polymères conviennent par exemple pour l'électro-greffage. D'autres exemples encore sont donnés ci-dessous.

La catégorie du deuxième matériau au sens de la présente invention, appelé ci-dessous aussi matériau de « renfort » lorsque celui ci renforce la fixation du premier matériau selon la présente invention. Il s'agit avantageusement d'un matériau minéral, pouvant s'agglomérer sur la surface, c'est-à-dire dont le mode de dépôt sur la surface est : soit une précipitation, c'est à dire par dépôt par gravité naturelle ou artificielle ; soit une cristallisation, par exemple une croissance cristalline ; soit un dépôt à l'état amorphe ; soit un électro-dépôt, à l'état amorphe ou cristallin ; soit un dépôt sous forme d'agrégats ou agrégation. De préférence, le deuxième matériau est un matériau qui peut être électrodéposé.

Selon la présente invention, le matériau de « renfort » peut être un matériau identique ou différent de celui constituant la surface qui doit être revêtue.

Comme cela apparaît clairement à la lecture de la présente description, l'appellation « renfort » ne préjuge pas du rôle du deuxième matériau dans la présente invention : en effet, le matériau dit de « renfort » qui correspond au deuxième matériau peut soit renforcer l'adhérence du premier matériau sur la surface, soit être lui même renforcé, ou bien son adhérence avec la surface, par le premier matériau dans le cas ou le premier matériau a le rôle d'armature au sens de la présente invention.

Dans la catégorie du deuxième matériau, parmi les matériaux utilisables dans la présente invention, on peut distinguer les suivants :
- les matériaux qui peuvent être électrodéposés : ce sont des matériaux, minéraux ou organiques, qui peuvent être déposés par voie électrochimique, et dont les dépôts sur une surface conductrice ou semi-conductrice de l'électricité résultent de préférence de réactions électro-suivies, c'est-à-dire de réactions électrochimiques où la quantité de matériau déposée est reliée, et le plus souvent proportionnelle, à la charge (= intégrale du courant) passée dans la cellule électrochimique de dépôt. En effet, ces réactions électrosuivies permettent un contrôle du dépôt et/ou de la formation du deuxième matériau à partir de son précurseur. Ainsi, le précurseur du deuxième matériau sera avantageusement un ion de ce matériau. Il peut s'agir notamment de réactions de dépôt d'un métal à partir d'une solution d'ions précurseurs de ce métal, par exemple de dépôt de cuivre à partir d'une solution contenant des ions cuivriques, de même que le dépôt de zinc, d'or, d'étain, du titane, du vanadium, du chrome, du fer, du cobalt, du lithium, du sodium, de l'aluminium, du magnésium, du potassium, du rubidium, du césium, du strontium, de l'yttrium, du niobium, du molybdène, du ruthénium, du rhodium, du palladium, de l'argent, du cadmium, de l'indium, du lutécium, de l'hafnium, du tantale, du tungstène, du rhénium, de l'osmium, de l'irridium, du platine, du mercure, du thalium, du plomb, du bismuth, des lanthanides et des actinides, à partir de leurs ions respectifs ; de dépôt de polymères isolants par électro-polymérisation de monomères précurseurs comme l'éthylène diamine ou les phénols ; de dépôt de polymères conducteurs par électro-polymérisation de monomères précurseurs comme le pyrrole, l'aniline, le thiophène, le méthyle thiophène, l'éthylène dioxythiophène (EDOT) et leurs dérivés ; de dépôt de polyélectrolytes par électrodéposition à partir de solutions les contenant ; et
- les matériaux qui ne peuvent pas être électrodéposés : il s'agit de matériaux qui peuvent être déposés sur la surface par précipitation, cristallisation, réticulation, agrégation, etc. La précipitation peut être réalisée sous l'effet de la gravité naturelle ou artificielle, sous forme d'agrégats, de globules, d'amas. Il peut s'agir notamment de réactions de précipitation ou de cristallisation de sels ioniques comme les hydroxyapatites, les hydrogénophosphates de calcium et/ou de magnésium, les halogénures d'argent, etc., et plus généralement de tous les sels insolubles, notamment dans l'eau; de réactions de réticulation d'oligomères ou de polymères aminés par des composés bi-fonctionnels comme l'épichlorhydrine, l'anhydride glutarique, le glutaraldéhyde ou les bis-époxy ; de réactions de réticulation d'oligomères ou de polymères hydroxylés par des composés bi-fonctionnels comme l'anhydride glutarique ou les diacides carboxyliques comme l'acide azélaïque ; de réactions de réticulation de polymères vinyliques par des réticulants polyvinyliques comme la di-vinyl benzène ou encore le penta-érythritol tétra-méthacrylate. D'autres exemples encore sont donnés ci-dessous.

L'expression « précurseur du deuxième matériau » dans la présente invention inclut bien entendu un seul précurseur du deuxième matériau ou un mélange d'au moins deux précurseurs choisis parmis les précurseurs du deuxième matériau cités dans la présente. Ainsi, par exemple, le précurseur du deuxième matériau peut être inséré au sein du premier matériau au moyen d'une solution ou bain d'un mélange de précurseurs tels que ceux précités, par exemple de sels de précurseurs.

Lorsqu'au moins deux précurseurs sont utilisés dans la mise en oeuvre de la présente invention, la transformation du précurseur en deuxième matériau au sein du premier matériau peut être réalisée de manière à transformer les différents précurseurs simultanément ou successivement indépendamment les uns des autres, par exemple en appliquant des conditions de précipitation, d'électrodéposition etc. appropriées. Ces modes particuliers de réalisation de la présente invention peuvent par exemple être utilisés pour la fabrication de catalyseurs.

Selon la présente invention, le matériau d'intérêt à déposer sur la surface peut appartenir à l'une ou l'autre des deux catégories précitées. En d'autres termes, comme précisé ci-dessus, le matériau d'intérêt peut être le premier ou le deuxième matériaux au sens de la présente invention :

Par exemple si le premier matériau est le matériau d'intérêt et s'il s'agit d'un matériau marcottable, son dépôt adhérent sur la surface est réalisé ou amélioré grâce au dépôt du deuxième matériau. Une fois le procédé terminé, on peut dire que le matériau d'intérêt, c'est à dire ici le premier matériau, a été marcotté par le deuxième matériau sur la surface.

Par exemple aussi, si le deuxième matériau est le matériau d'intérêt, et que son dépôt adhérent sur la surface est réalisé ou amélioré grâce au premier matériau choisi parmi les matériaux marcottables cités ci-dessus, une fois le procédé terminé, on peut dire que le deuxième matériau a été armé par le premier matériau sur la surface.

Suivant que le matériau d'intérêt est le premier ou le deuxième matériau selon l'invention, le principe de mise en oeuvre du procédé de la présente invention sera donc le plus souvent identique, à quelques détails quantitatifs près, si bien que ces expressions ne sont relatives qu'à l'intérêt que l'on porte à tel matériau plutôt qu'à celui qui permet d'assister son dépôt, et donc à l'application visée, mais pas au procédé : une relation biunivoque existe donc entre les listes de matériaux précités. C'est pourquoi ils ont été appelés « premier » et « deuxième » matériaux dans la définition du procédé de l'invention.

Un aspect particulièrement important de l'invention est que l'on parvient à obtenir une très bonne adhésion d'un matériau d'intérêt choisi dans l'une de ces deux catégories en combinant son dépôt avec celui d'un matériau complémentaire choisi dans l'autre catégorie.

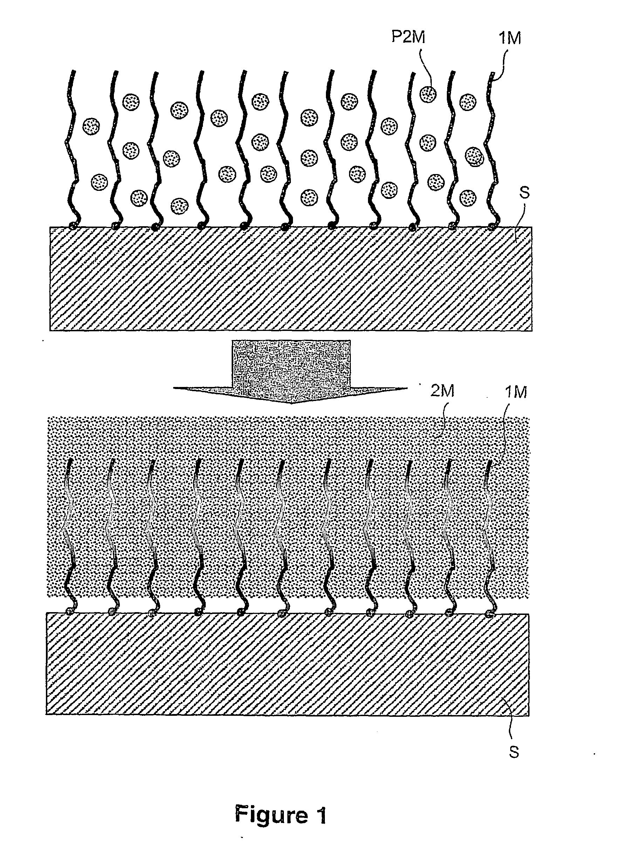

Ainsi, suivant un premier mode de réalisation du procédé de la présente invention, le premier matériau peut être fixé sur la surface, par exemple par chimisorption ou électro-greffage, sous la forme d'un matériau d'armature pour servir de fixation ou renforcer la fixation du deuxième matériau à la surface grâce au lien d'interface créé entre ce matériau d'armature et la surface : on dit, selon l'invention, que le dépôt du deuxième matériau sur la surface est armé par le premier matériau. Ce mode de réalisation est schématisé sur la figure 1 annexée. Ce mode de réalisation peut être réalisé par exemple de la manière suivante : le premier matériau est un polymère, par exemple un polymère organique, par exemple électro-greffé sur la surface. Le deuxième matériau est un métal déposé au sein du polymère par exemple sous la forme d'une couche. Le polymère sert ainsi « d'armature » de fixation à la couche de métal. Suivant ce mode de réalisation, le premier matériau peut être enfoui dans le deuxième matériau.

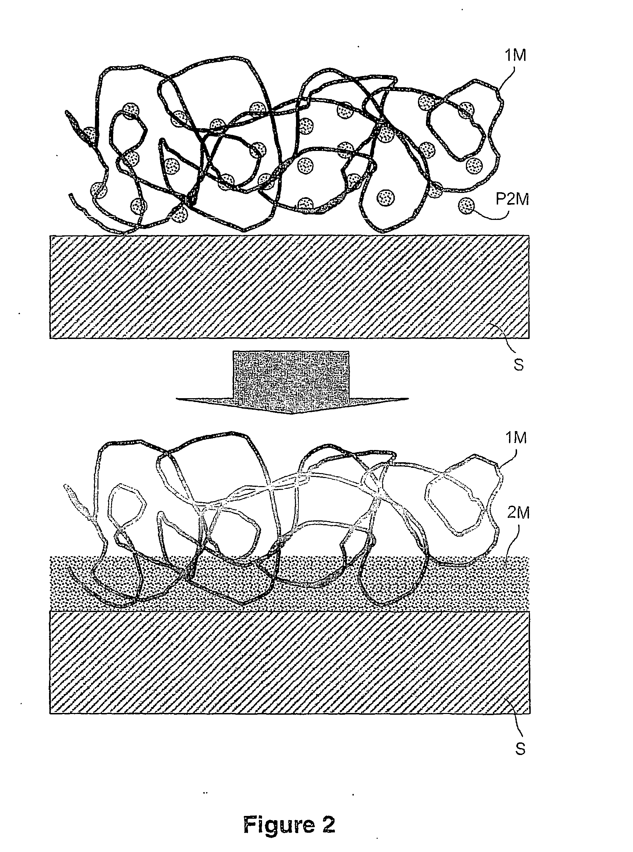

Suivant un deuxième mode de réalisation du procédé de la présente invention, le premier matériau peut être fixé sur la surface, par exemple par chimisorption ou électro-greffage, ou simplement déposé de façon non adhérente, sur la surface sous la forme d'un matériau de marcottage, et le deuxième matériau formé en son sein renforce la fixation du premier matériau à la surface grâce au lien d'interface créé entre ce deuxième matériau et la surface : on dit, selon l'invention, que la fixation ou le dépôt du premier matériau sur la surface est renforcée par le deuxième matériau. Ce mode de réalisation assure pour le premier matériau une interface plus solide que celle qui existe entre lui lorsqu'il est seul et la surface. Ce mode de réalisation peut être illustré de la même manière que le précédent, mais le matériau d'intérêt étant le premier matériau, on veillera à ce qu'il ne soit pas enfoui par le deuxième matériau lors de la formation de ce dernier à partir de son précurseur. Par exemple, le deuxième matériau, ici matériau de renfort, étant par exemple déposé par une réaction électro-suivie, on peut contrôler avantageusement la charge électrique lors son électrodéposition de manière à ce que sa croissance au sein du premier matériau, ou matériau marcottable, ne se produise qu'en son sein et n'enfouisse pas ce dernier. Par ce mode de réalisation de l'invention, on parvient à « plonger », en quelque sorte, les racines du premier matériau, qui est ici un polymère, dans le deuxième matériau qui peut être choisi de préférence pour sa compatibilité d'interface avec la surface. Cet exemple est schématisé sur la figure 2 annexée.

C'est ce deuxième mode de réalisation du procédé de la présente invention qui a suggéré aux présents inventeurs la dénomination de « marcottage électrochimique », le marcottage étant un procédé utilisé en botanique permettant de recréer des racines à partir de branches en les plongeant dans la terre de façon à ce qu'elles dépassent du sol.

Selon un mode particulièrement préféré des présents inventeurs, le procédé de l'invention peut être mis en oeuvre sur une surface qui est une surface conductrice ou semi-conductrice, le premier matériau est un polymère vinylique, le deuxième matériau est un métal, et le précurseur de ce métal est un ion de ce métal.

L'étape d'insertion du précurseur du deuxième matériau au sein du premier matériau selon le procédé de l'invention est une étape déterminante. En effet, c'est lors de cette étape que le précurseur du premier matériau est inséré au sein du deuxième matériau pour pouvoir ensuite y être transformé en deuxième matériau. Les techniques utilisables entrant dans le cadre de la présente invention pour cette étape sont nombreuses. Elles vont d'une simple mise en contact du précurseur du deuxième matériau avec le premier matériau disposé sur la surface, par exemple par trempage du premier matériau disposé sur la surface dans une solution appropriée dudit précurseur, à des techniques plus élaborées telles que l'utilisation d'un bain électrolytique.

Si le premier matériau ne permet pas une insertion aisée du précurseur du deuxième matériau en son sein, ou si cette insertion doit être favorisée, ou même forcée, selon l'invention, on peut avantageusement utiliser une solution d'insertion qui est à la fois un solvant ou transporteur du précurseur du deuxième matériau, et un solvant et/ou une solution qui gonfle le premier matériau, ladite solution d'insertion comprenant le précurseur du deuxième matériau.

Par exemple, un solvant du premier matériau lorsque celui-ci est un polymère est un solvant de ce polymère.

Par solution qui « gonfle » le premier matériau, on entend une solution qui s'insère au sein du premier matériau et qui en déploie la structure pour permettre l'insertion au sein du premier matériau du précurseur du deuxième matériau qu'elle contient. Par exemple, il peut s'agir d'une solution aqueuse, par exemple qui hydrate le premier matériau. On connaît par exemple des polymères vinyliques qui sont gonflés par l'eau, notamment la poly 4-vinyl pyridine, P4VP, qui n'est pas soluble dans l'eau ou encore le poly hydroxyéthyle méthacrylate, PHEMA, qui est soluble dans l'eau et donc également gonflé par ce solvant. Ces polymères peuvent être utilisés comme premier matériau selon la présente invention.

Cette solution d'insertion est également une solution qui permet de véhiculer le précurseur du deuxième matériau au sein du premier matériau. Il s'agira donc d'une solution qui permet une solubilisation ou une dispersion suffisante du précurseur pour la mise en oeuvre de la présente invention. En effet, dans le cas des sels insolubles du deuxième matériau, cette solution devra de préférence pouvoir disperser suffisamment le précurseur du deuxième matériau pour pouvoir l'insérer dans le premier matériau.

La solution d'insertion sera donc choisie en fonction de nombreux critères. Parmi ceux-ci, on peut citer : en fonction de la surface : par exemple pour éviter des interactions chimiques telle que l'oxydation de la surface au cours de la mise en oeuvre du procédé ; en fonction du premier matériau : de façon à ce que cette solution ne retire pas ce premier matériau de la surface sur laquelle il a été déposé ; en fonction du précurseur du deuxième matériau : elle doit permettre sa solubilisation, mais aussi sa transformation en deuxième matériau ; en fonction du deuxième matériau : elle doit permettre sa formation au sein du premier matériau, et notamment la réalisation de son procédé de dépôt, par exemple l'électrodépot du deuxième matériau.

Par exemple, l'art antérieur étant abondant d'une part sur l'obtention de films métalliques par électrodéposition à partir de solutions aqueuses, et d'autre part sur leur propriétés de solubilité dans l'eau, la solution d'insertion appropriée préférée selon l'invention est une solution aqueuse, notamment lorsque le premier matériau est un polymère qui peut être gonflé par l'eau, par exemple sous forme d'un film d'armature électro-greffé. D'autres solutions d'insertion et procédés d'insertion du précurseur du deuxième matériau au sein du premier matériau sont décrits ci-dessous. L'homme du métier saura choisir encore d'autres solvants d'insertion appropriés pour mettre en oeuvre la présente invention par exemple avec les précurseurs de la catégorie des matériaux de « renfort » précités.

Suivant un troisième mode de réalisation du procédé de la présente invention, l'étape consistant à insérer le précurseur du deuxième matériau au sein du premier matériau disposé sur ladite surface peut être réalisée en même temps que l'étape consistant à disposer sur ladite surface le premier matériau, au moyen d'une solution comprenant à la fois ledit premier matériau ou un précurseur dudit premier matériau, et le précuseur du deuxième matériau. Ce mode de réaliation est particulièrement avantageux par exemple lorsqu'il est difficile de trouver une solution d'insertion permettant de gonfler le premier matériau disposé sur le substrat. Ainsi, lors de la première étape consistant à disposer le premier matériau sur le substrat, le précurseur du deuxième matériau est pris au sein du premier matériau et, lorsque le premier matériau est disposé sur la surface, d'appliquer l'étape du procédé de l'invention consistant à transformer le précurseur du deuxième matériau en ledit deuxième matériau au sein dudit premier matériau.

L'étape de transformation de la présente invention est également importante, car elle doit permettre de transformer le précurseur du deuxième matériau en ledit deuxième matériau sur la surface à revêtir et au sein du premier matériau. Les modalités de cette transformation ont été décrites ci-dessus et sont détaillées d'avantage ci-dessous. De préférence, le précurseur du deuxième matériau peut être transformé en ledit deuxième matériau correspondant par une technique choisie parmi l'électrodéposition et la précipitation.

Le procédé de la présente invention peut donc comprendre, une fois que la surface qui doit être revêtue et que le matériau d'intérêt sont déterminés, la sélection d'un matériau complémentaire approprié, ainsi que la sélection des procédés de dépôt de chacun de ces deux matériaux suivant le procédé de la présente invention, qui permettront de réaliser une adhésion très forte dudit matériau d'intérêt sur ladite surface.

Dans un premier exemple d'application de l'invention, conforme au premier mode de réalisation précité, où l'on souhaite déposer de façon adhérente un matériau d'intérêt, qui est par exemple un matériau métallique (A) classé ci-dessus dans la catégorie du deuxième matériau, sur la surface d'un substrat, par exemple d'un semi-conducteur (B), le procédé de l'invention peut comprendre les étapes suivantes :
- sélection d'un matériau d'armature, ou premier matériau au sens de la présente invention, par exemple d'un polymère ;
- sélection d'un procédé de dépôt du matériau d'armature sur la surface, par exemple le semi-conducteur (B) : dans cet exemple c'est ce procédé de dépôt qui déterminera pour une large part la solidité du lien entre le matériau d'intérêt, métal (A), et la surface, ici le semi-conducteur (B) au final. Selon l'invention, l'homme de l'art pourra bien entendu choisir ce procédé en fonction de ce critère de solidité, mais aussi à partir d'autres considérations, notamment basées sur l'épaisseur du matériau marcottable désiré, par exemple sous la forme d'un film, sur l'homogénéité d'épaisseur désirée de ce matériau, sur le coût, etc. Une fixation très solide du matériau d'armature sur la surface, par exemple du semi-conducteur B, pourra par exemple être obtenue si le matériau d'armature est un polymère pouvant être électro-greffé sur la surface, par exemple le semi-conducteur B, puisque ce procédé permet de réaliser des liaisons chimiques covalentes entre un polymère et un conducteur ou un semi-conducteur ;
- sélection d'un procédé de dépôt du deuxième matériau au sens de la présente invention, ici métal A, de façon à ce qu'il soit compatible avec le procédé de dépôt du premier matériau, d'armature. Par compatibilité, on entend que ce procédé permet de préférence la croissance du matériau de renfort au sein du matériau d'armature : cela suppose notamment que les précurseurs du deuxième matériau, puissent tout d'abord s'insérer, c'est à dire diffuser, au sein, c'est à dire dans, le matériau d'armature, ou premier matériau, et que le procédé puisse y être appliqué pour permettre la formation du deuxième matériau au sein du matériau d'armature ;
- mise en oeuvre du procédé de l'invention tel qu'il est défini ci-dessus : si le deuxième matériau est un métal, on utilisera des ions métalliques de ce métal (A) en tant que précurseurs du deuxième matériau, dissous avantageusement dans un solvant et/ou un gonflant du matériau d'armature, par exemple du polymère, pour former la solution du précurseur du deuxième matériau ; Cette solution permet la diffusion des ions du précurseur au sein du polymère, puis on applique par exemple un procédé du type galvanique, par exemple électrodéposition (« electroplating » ou « Electro Chemical Deposition » (ECD) en anglais), pour former le métal (A) au sein du polymère. Ce procédé étant ici électro-suivi, un contrôle de la charge permet avantageusement de surveiller que la croissance du métal (A) se poursuit sur toute l'épaisseur du premier matériau, dans cet exemple du polymère formant le matériau d'armature, avant de se poursuivre sur sa surface.

De cette façon, le matériau marcottable, c'est à dire le polymère, ou premier matériau, se retrouve finalement enfoui dans le métal (A), auquel il a servi « d'armature » de fixation sur la surface métallique (B), grâce au lien d'interface créé entre le matériau d'armature et le semi-conducteur (B) : on dit que le dépôt du premier matériau, ici le métal (A), sur la surface, ici le semi-conducteur, a été armé par le premier matériau, ici le polymère. Cet exemple d'application est illustré sur la figure 1 annexée.

Il est par exemple démontré dans la partie « exemples » ci-dessous que l'on renforce ainsi de manière surprenante l'adhérence d'une couche de cuivre électrodéposée sur une surface d'or, ou l'adhérence d'un film de chlorure d'argent sur une surface métallique par un traitement préalable assurant un renfort polymérique enfoui de l'interface entre les deux métaux ou entre le métal et le chlorure d'argent.

Dans un deuxième exemple d'application de la présente invention, conforme au deuxième mode de réalisation précité, où l'on souhaite déposer un polymère (P), en tant que matériau d'intérêt marcottable, sur une surface, par exemple d'un substrat conducteur, par exemple en métal, le principe du procédé repose sur les mêmes étapes que celles décrites précédemment, sauf pour la dernière étape de mise en oeuvre. En effet, il est préférable dans cette dernière étape, comme précisé ci-dessus, de contrôler la croissance du deuxième matériau au sein du premier matériau de manière à ce qu'il n'enfouisse pas ce dernier.

Il est par exemple démontré dans la partie « exemples » ci-dessous, que grâce à ce deuxième mode de réalisation de l'invention, il est possible, de manière inattendue, de réaliser la fixation d'un film de poly-4-vinyl pyridine (P4VP) déposé par centrifugation sur une surface d'or, de façon à ce qu'il résiste à un rinçage drastique par un de ses solvants, alors que le film de P4VP seul, sur une même surface, est évacué par le même rinçage en l'absence de traitement selon l'invention.

Selon l'invention, lorsque l'objectif est que le matériau d'intérêt soit le seul des premier et deuxième matériaux présent à la surface lorsque la mise en oeuvre du procédé de l'invention est terminée, le procédé sera adapté, comme exposé dans la présente, soit de manière à ce que le premier matériau émerge du deuxième matériau, soit de manière à ce que le deuxième matériau immerge ou couvre le premier matériau.

Avantageusement, selon l'invention, le matériau d'intérêt émerge, ou couvre suivant le mode choisi de réalisation de l'invention, par exemple d'une épaisseur au moins égale à 20% de l'épaisseur totale formée par les deux matériaux sur la surface grâce au procédé de l'invention, suite à l'armature ou au marcottage. L'épaisseur de cette partie émergente est bien entendu adaptée en fonction de l'usage auquel cette surface est destinée.

L'épaisseur du revêtement formé par le premier et le deuxième matériau sur la surface en mettant en oeuvre le procédé de l'invention est en générale comprise entre 1 nm et 100 µm. Elle dépend bien entendu de la nature des matériaux utilisés, et du type de revêtement recherché.

Le revêtement obtenu grâce au procédé de la présente invention comprend donc le premier matériau et le deuxième matériau entremêlés, avec ou sans interactions ou liaisons chimiques entre eux, suivant la nature chimique des matériaux utilisés.

Le procédé de la présente invention présente donc de très nombreuses applications que l'homme du métier peut découvrir de lui même à la lecture de la présente description.

Parmi ces applications, on peut citer à titre d'exemples non limitatifs les suivantes :

Elle permet un renforcement d'interface entre un substrat conducteur ou semi-conducteur et un métal, par exemple grâce à une armature polymère préalablement greffée sur le substrat de la manière illustrée sur la figure 1 annexée. Cette application est intéressante pour le renforcement mécanique des interfaces cuivre/couche anti-diffusion telle que TiN, TaN, TiNSi, etc., notamment dans l'interconnexion cuivre en microélectronique, en particulier selon les procédés Damascene ou Dual Damascene.

Elle permet, plus généralement, de constituer une alternative intéressante aux sous-couches d'adhésion dans les interfaces métal/métal, métal/polymère conducteur, polymère conducteur/semi-conducteur ou métal/semi-conducteur.

Elle permet par exemple aussi le dépôt de couches organiques très adhérentes sur des substrats conducteurs ou semi-conducteurs, notamment pour l'anti-corrosion automobile, l'optique, les articles de mode, la lubrification mécanique, le dépôt de couches polymères thermofusibles pour les applications polymère « flip-chip », ou encore pour la fonctionnalisation de la partie sensible d'un capteur. Elle se rapporte donc également à l'utilisation du procédé de l'invention dans un traitement anti-corrosion d'une surface métallique.

Elle permet par exemple aussi le dépôt de couches organiques très adhérentes telles que le dépôt de polymères biocompatibles et/ou réservoirs d'encapsulation et de relargage de molécules actives sur des objets implantables conducteurs comme les empreintes pour le maintien de greffes en chirurgie plastique, ou les implants vasculaires (« stents » en anglais), les électrodes d'implants cochléaires, les guides de cathéters (« guidewires » en anglais), les implants orthopédiques et notamment les prothèses de hanche, les implants dentaires. Elle se rapporte donc également à l'utilisation du procédé de l'invention pour le traitement de surface d'un objet implantable dans un organisme.

Elle permet par exemple aussi le dépôt de couches organiques très adhérentes telles que le dépôt de macromolécules biologiques, ou de macromolécules porteuses de ou encapsulant des molécules biologiques comme des peptides, des protéines, des polysaccharides, des oligonucléotides ou des fragments d'ADN ou d'ARN, notamment pour la fabrication de biopuces à ADN ou à protéines. Elle se rapporte donc également à l'utilisation du procédé de l'invention pour la fabrication de biopuces.

Le procédé de la présente invention permet aussi la fabrication de catalyseurs, par exemple en utilisant comme précurseur du deuxième matériau les précurseurs métalliques précités ou un mélange de ceux-ci, par exemple un précurseur du rhodium, du platine, du palladium, du cobalt, du cuivre etc. ou un mélange de ceux-ci. Dans cette application, le premier matériau peut être un de ceux cités dans la présente, avantageusement un polymère comportant des fonctions pouvant servir de ligands pour la complexation des précurseurs du second matériau, comme par exemple la Poly-4-Vinyl Pyridine (P4VP), ainsi que tout polymère portant des groupement cystéine, qui peuvent être utilisés pour provoquer la fixation, sur une surface, d'un sel du catalyseur, par exemple de sels de palladium. Après réduction au sein du film du premier matériau, et éventuellement calcination du reliquat organique, on obtient le catalyseur sous sa forme métallique, par exemple du palladium métallique, soit à l'état de film soit à l'état d'agrégats métalliques. Les catalyseurs ainsi obtenus présentent en effet l'avantage d'initier le dépôt, pour un procédé de dépôt sans courant (« electroless process»), de couches de différents matériaux, et notamment de cuivre dans les applications liées à la micro-électronique (cf par exemple : S. James, H. Cho et al., « Electroless Cu for VLSI », *MRS Bulletin,* 20 (1993) 31-38) .

### Exposé détaillé de l'invention

L'idée sous-tendue par la mise en place des classifications ci-dessus est que des procédés sont connus pour :
- construire des interfaces très solides entre des matériaux organiques, notamment macromoléculaires, et en particulier des polymères, et des surfaces conductrices et semi-conductrices de l'électricité, mais la liste des matériaux organiques concernée est restreinte ;
- réaliser des dépôts adhérents de métaux sur d'autres métaux, mais à nouveau la liste des couples métal/surface parfaitement compatibles est limitée.

Comme indiqué ci-dessus, on sait en effet former des liaisons chimiques très solides entre des polymères et des surfaces conductrices ou semi-conductrices de l'électricité par électro-greffage de monomères vinyliques ou de molécules cycliques clivables par attaque nucléophile ou électrophile comme les lactones et les époxy. On sait également réaliser l'électro-greffage covalent de noyaux aromatiques fonctionnalisés, à partir de sels de diazonium ou de sels de sulfonium.

De façon complémentaire, on sait réaliser des dépôts adhérents de cuivre sur du cuivre ou sur la plupart des métaux de transition par électrodéposition, par exemple.

Selon l'invention, on utilise astucieusement ces méthodes de dépôt, de façon croisée, pour assister respectivement par exemple le dépôt de matériaux polymères qui ne peuvent pas être électro-greffés sur certaines surfaces, ainsi par exemple que celui de métaux qui présentent une faible adhérence sur certaines surfaces, par exemple sur des substrats conducteurs ou semi-conducteurs d'intérêt.

En outre, la présente invention utilise l'une de ces méthodes pour assister l'adhérence de matériaux qui ne forment traditionnellement pas de dépôts adhérents sur certaines surfaces, par exemple sur des conducteurs ou les semi-conducteurs, à savoir les solides ioniques.

On peut considérer que le revêtement formé sur la surface par la mise en oeuvre du procédé de l'invention est un revêtement composite, car il en présente toutes les caractéristiques. En effet, il comprend en général un premier matériau, de préférence organique et un deuxième matériau, de préférence minéral.

Ainsi, selon l'invention, lorsque l'objectif est d'armer une interface entre deux matériaux, par exemple un métal et un substrat semi-conducteur, comme représenté sur la figure 1 annexée. Un matériau d'armature constituant alors le premier matériau au sens de la présente invention est par exemple déposé par électro-greffage sur ladite surface, par exemple la surface du substrat semi-conducteur, et l'autre matériau, par exemple le métal, constituant le deuxième matériau au sens de la présente invention, est formé à partir de son précurseur au sein du matériau d'armature. La formation du deuxième matériau, par exemple lorsqu'il s'agit d'un métal, est avantageusement obtenue soit par électrodéposition, soit précipitation chimique du précurseur de ce deuxième matériau. Dans cet exemple, lorsque l'opération est terminée, le matériau d'armature est enfoui.

Selon l'invention, lorsque l'objectif est de marcotter un matériau organique, constituant le premier matériau au sens de la présente invention, sur une surface, par exemple d'un substrat conducteur ou semi-conducteur, le matériau de renfort, constituant le deuxième matériau au sens de la présente invention, est construit au sein dudit matériau organique avantageusement par électrodéposition, par exemple par électrolyse, ledit matériau organique ayant été déposé sur le substrat par un moyen quelconque approprié, par exemple par centrifugation, par trempage ou par pulvérisation.

La notion d'adhérence d'un revêtement sur une surface est une notion relativement subjective, car son appréciation dépend de la sollicitation que subit ensuite le revêtement en conditions d'utilisation. Ainsi, par exemple, l'électro-greffage est un procédé connu pour former des films polymères sur des conducteurs ou semi-conducteurs qui résistent à des rinçages sous ultrasons.

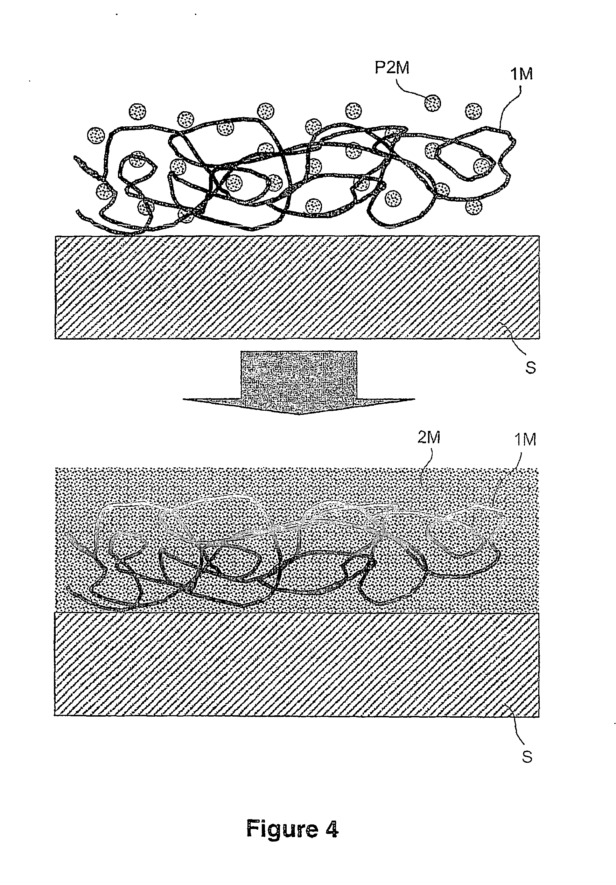

Tout polymère déposé selon la présente invention sur une surface par simple centrifugation puis renforcé par un deuxième matériau au sens de la présente invention, par exemple un métal, comme représenté sur les figures 1 et 4 annexées, forme un revêtement armé dont l'adhérence sur la surface est améliorée par rapport à un dépôt du polymère seul, sans renfort sur ladite surface, sans préjuger de la nature de l'interface qui aura été construite entre le matériau de renfort et la surface.

Dans bien des cas, cette « résistance à l'évacuation » du polymère de la surface du substrat peut s'avérer suffisante, si bien qu'on peut compléter la liste des procédés ci-dessus en considérant que, pour un renfort d'interface tel que représenté sur la figure 1 annexée :
- les matériaux polymères ou macromoléculaires d'armature, constituant le premier matériau, peuvent être déposés par électro-greffage, par centrifugation, par trempage ou par pulvérisation ;
- les matériaux de renfort, constituant le deuxième matériau, peuvent être déposés par électrodéposition ou par précipitation chimique.

C'est la raison pour laquelle matériaux d'armature et matériaux marcottables sont rangés dans la même catégorie selon la classification initiale : on peut dire par exemple qu'un matériau organique, polymère ou macromoléculaire, est « d'armature » s'il est complètement enfoui suite au dépôt du matériau de renfort, et « marcotté » s'il n'est pas complètement enfoui. Dans le premier cas, l'utilisateur aura choisi de l'enfouir parce que le matériau de renfort est le matériau d'intérêt ; dans le second, l'utilisateur aura choisi de ne pas l'enfouir pour bénéficier de ses propriétés une fois le renfort établi.

Ainsi, par exemple pour l'application de la présente invention à l'adhésion des pistes de cuivre sur TiN dans le procédé Damascene en microélectronique, le matériau d'intérêt est le cuivre, dont on souhaite améliorer l'interface avec le TiN pour des raisons mécaniques : on peut déposer un film de P4VP sur TiN par électro-greffage ou par centrifugation, avant de l'enfouir dans une couche de cuivre électrodéposée comme représenté sur la figure 1. A l'inverse, on peut réaliser le dépôt de P4VP de haut poids moléculaire sur une surface d'inox ou de graphite de grande surface pour fabriquer un filtre de complexation utilisable dans un dispositif de traitement d'effluents liquides, et pour cela imprégner la surface avec la P4VP, puis tremper cette surface dans une solution contenant des ions métalliques pour qu'ils s'insèrent dans le film polymère, et enfin réduire le cuivre ainsi piégé de façon à ce que les groupements pyridines complexants soient encore accessibles au-dessus du métal de renfort.

Par ailleurs, si un premier matériau disposé sur une surface par un procédé approprié présente une forte adhérence à la surface, et que, indépendamment de ce premier matériau, le deuxième matériau présente lui aussi une forte adhérence à cette surface, le procédé de la présente invention permet avantageusement en quelque sorte de cumuler les adhérences de ces deux matériaux sur ladite surface. La présente invention fournit donc des revêtements ultra-résistants qui ont de très nombreuses applications.

Il est bien évident que l'enfouissement de l'un ou l'autre des matériaux n'est pas une nécessité. Le procédé de l'invention sera bien entendu adapté suivant l'usage auquel le revêtement est destiné.

Quelle que soit l'application considérée de la présente invention, en particulier les procédés de dépôt choisis, on observe que l'étape de dépôt des matériaux d'armature ou des matériaux à marcotter, qui constituent le premier matériau au sens de la présente invention, s'effectue toujours avant celle des matériaux de renfort, qui constituent le deuxième matériau au sens de la présente invention, comme cela est représenté sur les figures 1, 2 et 4 annexées.

Une fois le premier matériau, par exemple organique, polymère ou macromoléculaire, est disposé sur une surface d'un substrat, par exemple un substrat conducteur ou semi-conducteur, il est donc nécessaire que les précurseurs du deuxième matériau, par exemple de renfort, puissent être insérés, par exemple par électrodéposition ou précipitation, au sein du premier matériau.

Cette insertion peut se faire par simple contact du précurseur du deuxième matériau, de préférence au moyen d'une solution de celui-ci, avec le premier matériau disposé sur la surface.

Ainsi, selon l'invention on sélectionne avantageusement le solvant de l'étape d'insertion de façon à ce qu'il permette à la fois la solubilisation du précurseur du deuxième matériau et si nécessaire le gonflement et/ou la solubilisation du premier matériau, par exemple du film organique d'armature ou à marcotter, de manière à favoriser au mieux l'insertion du précurseur.

Par exemple, dans le cas où le premier matériau est un polymère, on peut choisir avantageusement la solution contenant le précurseur du deuxième matériau parmi les liquides gonflants mais non solvants du polymère ou les solvants du polymère. En particulier, si le premier matériau est un polymère qui a été électro-greffé, on peut choisir les liquides gonflants mais non solvants du polymère, mais aussi les solvants du polymère car ce dernier ne peut pas être décroché de la surface par ces solvants, et donc par la solution du précurseur que ces solvants forment.

Par contre, si le premier matériau, par exemple organique, a été déposé par centrifugation ou trempage pour former une armature ou un marcottage, une solution constituée à partir d'un simple solvant gonflant du polymère, aussi peu solvant que possible, sera préférentiellement utilisée de manière à éviter de laver le polymère de la surface sur laquelle il a été préalablement déposé.

Par exemple, dans le cas où le premier matériau est la P4VP, ce polymère peut facilement être électro-greffé ou déposé, par centrifugation ou trempage, à partir d'une solution dans la diméthylformamide (DMF), qui est un bon solvant du polymère. Une fois le solvant évaporé, on peut, dans un cas comme dans l'autre, tremper la surface sur laquelle il ce premier matériau est disposé dans une solution aqueuse, car l'eau est un bon gonflant mais un mauvais solvant de la P4VP.

Dans ces conditions, selon l'invention, l'insertion du précurseur du deuxième matériau, par exemple des ions, peut se faire « naturellement », par simple diffusion dans le polymère, par exemple par trempage dans une solution contenant les ions précurseurs du deuxième matériau. Cette diffusion est en général d'autant plus rapide que le bain de précurseur est plus concentré.

Les inventeurs ont observé ainsi qu'un film de P4VP sur inox d'une centaine de nanomètres d'épaisseur est saturé en ions cuivre en quelques minutes à température ambiante lorsque la surface plonge dans une solution à 20 g/l en sulfate de cuivre.

De manière avantageuse, la saturation du premier matériau, par exemple sous la forme d'un film, par le précurseur du deuxième matériau peut encore être facilitée par la présence au sein du premier matériau de groupements fonctionnels aptes à retenir le précurseur du deuxième matériau, par exemple en le complexant lorsqu'il est sous la forme d'ions précurseurs. Cette rétention peut être assurée par le biais de liaisons ioniques, de liaisons datives ou interactions de type acide-base de Lewis, de liaisons covalentes ou de liaisons hydrogènes, ou encore par rétention mécanique (absence de possibilité de diffusion en dehors du premier matériau), comme par exemple lorsque le précurseur du second matériau est précipité au sein du premier matériau.

Par exemple dans l'exemple précité, les ions cuivriques, formant le précurseur du deuxième matériau qui est du cuivre, sont très bien complexés par les doublets libres des azotes pyridiniques de la P4VP formant le premier matériau.

Avantageusement, le premier matériau, par exemple un polymère, peut donc être choisi en fonction du précurseur du deuxième matériau, notamment lorsque ce dernier est sous la forme d'ions, de façon à ce que ce premier matériau contienne des groupements qui complexent le précurseur de façon satisfaisante pour qu'il reste inséré au sein du polymère.

Une fois que le précurseur du deuxième matériau est inséré dans le premier matériau, par exemple dans le film de polymère, on peut procéder avantageusement soit à son électroréduction, soit à sa précipitation, au sein du film de manière à former au sein dudit premier matériau ledit deuxième matériau.

Par exemple, si l'objectif est de réaliser une armature du deuxième matériau au moyen du premier matériau, par exemple dans le cas du renfort d'interface dans le procédé Damascene, l'électroréduction du précurseur du deuxième matériau, par exemple du cuivre, peut avantageusement être réalisée dans le même bain que celui utilisé pour saturer le film avec ledit précurseur, puisque l'objectif dans cet exemple est que la croissance du matériau de renfort se poursuive au-delà de l'épaisseur du matériau d'armature. Les figures 1 et 4 illustrent schématiquement cet exemple.

Par exemple, Si l'objectif est au contraire de marcotter un film organique formant le premier matériau, la surface portant le film organique gonflé d'ions précurseurs peut être avantageusement sortie de la solution du précurseur, puis trempée dans un bain électrolytique ne contenant pas les ions précurseurs.

Dans ce dernier exemple, selon la présente invention, la présence de groupements fonctionnels complexant les ions dans le film, ralentira avantageusement la sortie des ions du film dans la nouvelle solution car l'inversion des gradients de concentration entre le précurseur inséré au sein du premier matériau et la solution du précurseur, et entre le précurseur inséré au sein du premier matériau et la solution formée par le bain électrolytique sans précurseur entraîne l'inversion des courants de diffusion du précurseur. Les inventeurs ont en effet observé par spectroscopie Infra-Rouge en réflexion (IRRAS) qu'un film de P4VP de 100 nm d'épaisseur sur inox, saturé en ions cuivriques, conserve ses ions même après un séjour de plusieurs heures dans une solution aqueuse saturée en chlorure de sodium.

Si le deuxième matériau est formé à partir de son précurseur par électrodéposition, la quantité du deuxième matériau déposée au sein du premier matériau, par exemple d'un film à marcotter, peut avantageusement être contrôlée par contrôle du potentiel d'électrodéposition. En outre, le fait de réaliser le deuxième matériau uniquement à partir de son précurseur inséré au sein du premier matériau et dans un bain électrolytique ne contenant pas de précurseur du deuxième matériau assure avantageusement que le film à marcotter ne soit pas enfoui par le deuxième matériau. Ce mode particulier de réalisation de la présente invention permet donc d'assurer, lorsque cela est nécessaire, que le premier matériau, lorsqu'il s'agit d'un matériau de marcottage, ne soit pas enfoui par le deuxième matériau.

Comme cela apparaît dans la présente description, le premier matériau peut être disposé sur la surface au moyen de tout procédé connu de l'homme du métier. Le terme « disposé » est utilisé dans la présente pour désigner de manière générale tout type de dépôt connu de l'homme du métier, par exemple la pulvérisation, le trempage, la centrifugation, l'électro-greffage, l'électrodéposition, etc. Selon l'invention, le procédé pour disposer le premier matériau sur la surface sera choisi par l'opérateur en fonction notamment de la nature de la surface et de la destination du revêtement fabriqué par la mise en oeuvre du procédé de l'invention, en particulier du type d'adhérence recherchée sur la surface.

Selon l'invention, quelque soit le procédé choisi pour disposer le premier matériau sur la surface, de manière préférée, le premier matériau peut être disposé sur la surface à revêtir sous forme d'un film ou couche, et de préférence encore d'un film ou couche organique.

De manière préférée, selon l'invention, et lorsque cela est possible en raison de la nature de la surface, le premier matériau peut être disposé sur la surface à revêtir au moyen d'un électro-greffage. L'électro-greffage peut être en effet avantageusement utilisé lorsque la surface qui doit être revêtue au moyen du procédé de l'invention est une surface conductrice ou semi-conductrice. Il permet d'obtenir une fixation forte du premier matériau sur la surface.

Selon l'invention, le premier matériau peut avantageusement être réalisé à partir d'un précurseur de celui-ci, appelé ci-dessous précurseur du premier matériau, choisi dans le groupe constitué des monomères vinyliques, activés ou cycliques, des sels de diazonium fonctionnalisés ou non, des sels de sulfonium fonctionnalisés ou non, des sels de phosphonium fonctionnalisés ou non, des sels d'iodonium fonctionnalisés ou non. En effet, le premier matériau peut être obtenu avantageusement à partir d'un ou de plusieurs de ces précurseurs, par exemple par réaction d'électro-greffage sur la surface, par exemple d'un support conducteur ou semi-conducteur de l'électricité. En effet, l'électro-greffage de ces précurseurs sur la surface conduit avantageusement à disposer un film du premier matériau sur la surface au sens de la présente invention.

Selon l'invention, le premier matériau peut être obtenu avantageusement à partir d'un précurseur de celui-ci, appelé précurseur du premier matériau, choisi dans le groupe constitué des monomères vinyliques activés, des molécules cycliques clivables par attaque nucléophile, et des sels de diazonium.

Par exemple, les monomères vinyliques activés utilisables dans la présente invention peuvent être ceux ayant la structure (I) suivante : 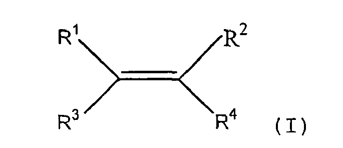 dans laquelle R¹, R², R³, R⁴, sont des groupements organiques choisis indépendamment les uns des autres dans le groupe constitué des fonctions organiques suivantes : hydrogène (H), hydroxyles (-OH), amine (par exemple -NHₓ, avec x = 1 ou 3), thiol (-SH), acide carboxylique (-COOH), ester (par exemple -COOR⁵, avec R⁵ étant un alkyl en C1 à C6), amide (par exemple -C(=O)NH_{y}, avec y = 1 ou 2), imide, imido-ester, halogénure d'acide (par exemple C(=O)X, X = F, Cl, Br, I), anhydride d'acide (par exemple -C(=O)OC(=O)), nitrile, succinimide, phtalimide, isocyanate, époxyde, siloxane (par exemple -Si(OH)_{z}, avec z = 1 ou 3), benzoquinone, benzophénone, carbonyle-diimidazole, para-toluène sulfonyle, para-nitrophényl chloroformiate, éthylénique, vinylique, aromatique par exemple toluène, benzène, halogéno-benzène, etc.

En outre, au moins un de R¹, R², R³, R⁴ peut être un groupement fonctionnel pouvant complexer des cations et notamment des cations de métaux réductibles, comme le cuivre, le fer, le nickel, etc. par exemple choisi dans le groupe constitué des amines, des amides, des éthers, des carbonyles, des carboxyles et des carboxylates, des phosphines, les oxydes de phosphines, les thio-éthers, des disulfures, des urées, les éther-couronnes, des aza-couronnes, des thio-couronnes, des cryptands, de « sepulcrates » (terme anglais), des podands, des porphyrines, des calixarènes, des pyridines, des bipyridines, des terpyridines, des quinoléines, des composés de l'orthophénantroline, des naphtols, des iso-naphtols, des thiourées, des sidérophores, des antibiotiques, de l'éthylène glycol, des cyclodextrines.

Le film du premier matériau peut également être obtenu à partir de structures moléculaires substituées et/ou fonctionnalisées à partir des groupes fonctionnels précités. Peuvent également convenir comme précurseurs du premier matériau tous composés, de taille moléculaire ou macromoléculaire, porteur de groupements vinyliques tels que ceux indiqués ci-dessus, comme les téléchéliques a extrémités vinyliques, et en particulier les téléchéliques mono- et di-méthacrylate comme par exemple le Polyéthylène glycol di-méthacrylate ou le poly di-méthyle siloxane di-méthacrylate, ou encore les macromères vinyliques c'est-à-dire les composés macromoléculaires mono- ou poly-fonctionnalisés par des groupements vinyliques. Dans cette dernière catégorie entrent par exemple les polymères (les polymères vinyliques, comme l'alcool polyvinylique, l'acide polyacrylique ou polyméthacrylique, la poly allylamine ... etc ; les poly condensats, comme l'acide polylactique, l'acide polyglycolique, les poly orthoesters, les polyamides ... etc, la poly éthylèneimine...), ou co-polymères, dont tout ou partie des groupements fonctionnels pendants ont été fonctionnalisés par des groupements vinyliques. On peut ainsi, par exemple, obtenir un précurseur du premier matériau en faisant réagir le chlorure de méthacryloyle ou le méthacrylate de glycidyle sur tout ou partie des groupements fonctionnels OH ou NH d'un polymère, comme l'alcool polyvinylique ou la poly allylamine, et produire respectivement un alcool polyvinylique et une poly allylamine fonctionnalisée par des groupements méthacrylate. Plus généralement, peuvent constituer des précurseurs du premier matériau les macromolécules non polymériques, comme les polysaccharides (dextranes, celluloses, héparine, chitosanes...etc), les protéines (fibrine, caséine...etc), les oligonucléotides (ADN, ARN, simple et double brin...), les peptidoglycanes, dont tout ou partie de certains de leurs groupements fonctionnels ont été fonctionnalisés par des groupements vinyliques. Un dextrane-GMA, fonctionnalisé par des groupements glycidyle méthacrylate, est par exemple obtenu à partir d'un dextrane de masse M = 15000 et de méthacrylate de glycidyl (2,3-epoxypropyl méthylpropénoate), selon le protocole décrit dans W.N.E. par van Dijk-Wolthuis, O. Franssen, H. Talsma, M.J. van Steenbergen, J.J. Kettenes-van den Bosch, W.E. Hennink, Macromolecules, 1995, 28, 6317. Un film de 200 nm d'épaisseur est obtenu par électro-greffage sur or en conditions voltammétriques avec 15 balayages de Eᵢₙᵢₜᵢₐₗ = - 0,6 V/(Ag⁺/Ag) à E_{final} = - 2,8 V/(Ag⁺/Ag) à une vitesse de 100 mV/s, en plongeant une lame d'or, utilisée comme électrode de travail dans un montage à 3 électrodes, dans une solution obtenue en dissolvant 0,25 g du dextrane-GMA dans 50 ml de DMF à 10⁻² mol/l en TEAP (la solution est donc environ à 3,3.10⁻⁴ mol/l en dextrane-GMA). Du fait qu'il a été déposé par électro-greffage, ce film est très adhérent sur la surface et résiste notamment à des rinçages sous ultra-sons. Il constitue donc un premier matériau de choix, pouvant accueillir les précurseurs d'un second matériau, et en particulier des sels métalliques, notamment par trempage de la lame dans un solvant ou un gonflant contenant ces précurseurs métalliques.

Enfin, le film du premier matériau pourra être également obtenu à partir de mélanges des composés précurseurs chimiques pré-cités, de façon à obtenir des films de co-polymères, éventuellement initiés par des sels de diazonium, constituant le premier matériau au sens de la présent invention.

Par exemple, selon l'invention, lorsque le premier matériau est un polymère obtenu par polymérisation d'un monomère précurseur vinylique, il peut avantageusement être choisi dans le groupe constitué des monomères vinyliques comme l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle, les acrylamides et notamment les méthacrylamides d'amino- éthyle, propyle, butyle, pentyle et hexyle, les cyanoacrylates, les cyanométhacrylates, le polyéthylène glycol di-méthacrylate et plus généralement les téléchéliques di-acrylates ou di-méthacrylates, l'acide acrylique, l'acide méthacrylique, le styrène, le parachloro-styrène, la N-vinyl pyrrolidone, la 4-vinyl pyridine, la 2-vinyl pyridine, les halogénures de vinyle, le chlorure d'acryloyle, le chlorure de méthacryloyle, le di-Vinyl Benzène (DVB), le penta-érythritol tétraméthacrylate et plus généralement les agents réticulants à base acrylate, méthacrylate ou vinylique, et de leur dérivés.

Par exemple, les molécules cycliques clivables par attaque nucléophile utilisables dans la présente invention peuvent être ceux ayant la structure (II) suivante : 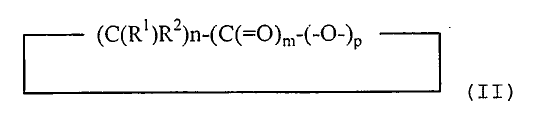 dans laquelle R¹ et R² sont indépendamment tels que définis ci-dessus, et dans laquelle n, m et p sont chacun indépendamment des nombres entiers de 0 à 20. Dans cette catégorie entrent par exemple les époxydes (R¹ étant un groupement alkyl tel que listé précédemment, R²=H, n = 1, m = 0, p = 1), tels que l'oxyde d'éthylène (R¹ = H, R² = H) ; les lactones (R¹ et R² étant des groupements alkyls tels que listés précédemment, m = 1, p = 1), comme la butyrolactone (n = 2 : R¹₁ = H, R²₁ = H, R¹₂ = H, R²₂ = H ; m = 1, p = 1), l'ε-caprolactone (n = 5 : R¹ᵢ = H, R²ᵢ = H, 1 ≤ i ≤ 5 ; m = 1, p = 1) ...etc.

Par exemple, les sels de diazonium utilisables dans la présente invention peuvent être ceux ayant la structure (III) suivante :

X⁻, N₂⁺-Φ-R³ (III)

dans laquelle R³ est tel que défini ci-dessus,
dans laquelle Φ est un noyau aromatique, et
dans laquelle X est un contre-ion chargé négativement, par exemple choisi dans le groupe constitué par un tétrafluoroborate, un halogénure, un sulfate, un phosphate, un carboxylate, un perchlorate, un hexafluorophosphate, un ferrocyanure, un ferricyanure.

Des exemples de sels de diazonium utilisables pour constituer le premier matériau au sens de la présente invention sont par exemple les tétrafluoroborates de 4-nitrophényl diazonium (dont le groupement nitro est réductible en amine présentant des propriétés complexantes), de 4-carboxy benzènediazonium (R³ = COOH) et plus généralement de benzènediazonium substitués en para par des groupements ayant des propriétés complexantes, et notamment ceux porteurs de groupements acide carboxylique (-(CH₂)ₙ-COOH, avec n un nombre entier allant de 1 à 10), l'EDTA (éthylène diamine tétra-acétate) et ligands analogues, etc. ; la bipyridine, les quinoléines, les acides aminés et les protéines, les mono- et polysaccharides, etc.

Tous ces composés chimiques précurseurs du premier matériau pourront bien entendu être utilisés seuls ou en mélange suivant l'objectif de l'opérateur qui met en oeuvre l'invention.

Le premier matériau sera bien entendu choisi en fonction de nombreux critères qui notamment sont la nature chimique de la surface, du matériau d'intérêt, la nature chimique du deuxième matériau si celui-ci n'est pas le premier matériau, ainsi que la destination du revêtement fabriqué conformément au procédé de la présente invention. Par exemple, dans le cas où l'on souhaite armer une couche métallique par la mise en oeuvre du procédé de l'invention, on peut utiliser avantageusement des monomères précurseurs d'un premier matériau sous forme de polymère, ledit polymère étant avantageusement porteurs de groupements fonctionnels permettant la complexation du précurseur du deuxième matériau par exemple lorsque ce dernier est sous forme d'ions.

Tous ces composés chimiques précurseurs du premier matériau pourront être utilisés avantageusement directement sur la surface, par exemple lorsque l'initiation de leur polymérisation est provoquée directement par la surface métallique mise sous potentiel de la manière représentée sur la figure 3 annexée ; ou bien en mélange avec des initiateurs électro-activables, qui, une fois réduits ou oxydés sur la surface, initient eux-mêmes la polymérisation : sels de diazonium, sels de sulfonium, sels de phosphonium, sels d'iodonium, peroxo-disulfates, persulfates, thiosulfates, ferrocène, acides carboxyliques et notamment benzoïques, péracides etc. et de manière général tous les composés électro-actifs conduisant à la formation de radicaux initiateurs une fois réduits ou oxydés.

L'étape du procédé de l'invention consistant à déposer sur la surface le premier matériau, peut être une étape consistant à obtenir un film ou couche organique du premier matériau à partir de ses composés chimiques précurseurs précité. Elle peut se faire par exemple avantageusement par électrolyse en milieu totalement ou partiellement organique, selon différents protocoles de mise sous potentiel connu de l'homme de l'art. Parmi ceux-ci on peut citer les suivants : courant nominal en conditions intentiostatiques, voltammétrie, nombre de balayages en conditions voltammétriques, multicréneaux de potentiel, saut intentiostatique, saut potentiostatique, etc.

Le milieu utilisé pour disposer le premier matériau sur la surface par ces techniques peut comprendre par exemple un solvant organique, comme la diméthyl formamide (DMF), l'acétonitrile, l'eau, les alcools, ou un mélange de ces solvants, et éventuellement un électrolyte support comme le perchlorate de tétra méthyle, éthyle, propyle ou butyle Ammonium (respectivement TMAP, TEAP, TPAP, TBAP), de lithium, de sodium, de potassium, le chlorure de sodium ou de potassium, le nitrate de sodium ou de potassium, et plus généralement tout sel substantiellement soluble dans le milieu d'électrosynthèse.

A titre d'exemple, un film de poly-4-vinyl pyridine (P4VP) sur or de 20 à 40 nm d'épaisseur, utilisable dans la présente invention, peut être obtenu en réalisant des balayages voltammétriques de -0,7 à -2,9 V/ (Ag⁺/Ag) à 200 mV/s sur une surface d'or plongée dans une solution à 95% en volume de 4-vinyl pyridine dans la DMF, en présence de 5.10⁻² mol/l de TEAP. La fenêtre d'épaisseur citée correspond des nombres de balayages voltammétriques différents, l'épaisseur médiane (30 nm) étant obtenue avec 50 balayages. Toutes choses étant égales par ailleurs on obtient un film de 100 à 150 nm d'épaisseur en rajoutant à la solution précédente 5% en volume de penta-érithrytol tétra-méhacrylate, et en réalisant la co-polymérisation simultanée de ces deux monomères.

A tire d'exemple aussi, on obtient, de façon similaire, un film de poly-méthacrylonitrile (PMAN) sur or d'environ 50 nm d'épaisseur, utilisable dans la présente invention, en effectuant 10 balayages voltammétriques de -0,5 à -2,7 V/(Ag⁺/Ag) à 50 mV/s sur une surface d'or plongée dans une solution à 2,5 mol/l de méthacrylonitrile dans la DMF, en présence de 5.10⁻² mol/l de TEAP. On identifie les groupements nitrile du polymère formé par la bande à 2235 cm⁻¹ en IRRAS.

A titre d'exemple aussi, on obtient la formation d'un film électro-greffé de poly-hydroxyéthyl méthacrylate (PHEMA) sur or d'environ 40 nm d'épaisseur, également utilisable dans la présente invention, en réalisant 10 balayages voltammétriques de +1,0 à -3,0 V/(Ag⁺/Ag) à 50 mV/s sur une surface d'or plongée dans une solution à 0,4 mol/l d'hydroxyéthyl méthacrylate dans la DMF, en présence de 5.10⁻² mol/l de TEAP (Tétra Ethyl Ammonium Perchlorate).

A titre d'exemple aussi, on obtient un film de 300 nm de PHEMA, utilisable dans la présente invention, sur inox 316L en réalisant 40 balayages voltammétriques de -0,6 à -3,0 V/(Ag⁺/Ag) à 100 mV/s sur une surface d'inox plongée dans une solution à 3,5 mol/l d'hydroxyéthyl méthacrylate (HEMA) dans la DMF, en présence de 2,5.10⁻² mol/l de NaNO₃, et 10⁻² mol/l de tétrafluoroborate de 4-nitrophényl diazonium.

A titre d'exemple aussi, on obtient un film greffé ultramince couvrant d'alkyl benzène (R-Φ-) d'épaisseur estimée inférieure à 50 nm (et quasiment proportionnelle à la taille du groupement alkyl R), utilisable dans la présente invention, sur une surface de nitrure de titane en réalisant 3 balayages voltammétriques de +1,15 à -1,52 V/(Ag⁺/Ag) à 20 mV/s sur une lame de TiN plongée dans une solution à 5.10⁻³ mol/l de tétrafluoroborate de l'alkyl phényl diazonium dans l'acétonitrile, en présence de 5.10⁻² mol/l de TEAP.

Les conditions de concentration en précurseur du premier matériau au sens de la présente invention, par exemple monomère ou sel de diazonium, sont variables d'un précurseur à l'autre et de l'objectif de l'opérateur qui met en oeuvre l'invention. En effet, la concentration en précurseur du premier matériau a un impact sur sa disposition sur la surface dans la première étape du procédé de l'invention, mais aussi sur les autres étapes du procédé de l'invention, c'est à dire d'insertion du précurseur du deuxième matériau au sein du premier matériau et de formation du deuxième matériau à partir de son précurseur, ainsi que sur les propriétés du revêtement obtenu.

On pourra cependant considérer comme préférentielles les concentrations comprises entre 0,1 et 10 mol/l, et en particulier entre 0,1 et 5 mol/l pour les monomères, et 10⁻⁴ et 1 mol/l, et en particulier 10⁻³ et 0,1 mol/l pour les sels de diazonium. L'homme du métier saura aisément adapter ces fourchettes de concentration à l'usage qu'il fera de la présente invention.

Tous ces composés chimiques précurseurs du premier matériau ont en commun le fait qu'ils permettent d'aboutir avantageusement à la formation de structures de type « brosses », comme esquissé sur le haut de la figure 1 annexée, bien configurées pour servir de structures d'armature, pour le dépôt de solides d'ordinaire non adhérents, conformément au procédé de la présente invention.

Le schéma de la figure 1 donne une indication de ce qui peut être obtenu à taux de greffage, c'est à dire nombre de pieds de polymère par unité de surface, élevé.

Avec un taux de greffage moins élevé, on obtiendra plus souvent des structures polymères ou « cheveux » couchés sur la surface, dont les propriétés d'armature peuvent être sensiblement moins bonnes que celles de structures en brosses, mais qui remplissent généralement la fonction voulue conformément à la présente invention.

De façon générale, qu'il s'agisse de réaliser l'électro-greffage de composés chimiques précurseurs du premier matériau de type sels de diazonium ou de type monomères, le taux de greffage peut avantageusement être ajusté par la quantité de courant passée dans le circuit électrique utilisé. En effet, toutes ces réactions d'électro-greffage sont des réactions électro-initiées, où seule l'étape de fixation du premier précurseur consomme un électron comme cela est représenté sur la figure 3 annexée, ce qui lui vaut d'occuper un site de la surface. La croissance, lorsqu'elle existe, c'est à dire dans le cas des précurseurs monomères de polymères, est ensuite purement chimique. Le courant passé, ou plus exactement la charge passée, c'est à dire la charge intégrale du courant, est donc reliée au nombre de sites de la surface qui ont été occupés, et donc à la morphologie du film formé. L'homme de l'art pourra donc aisément pré-déterminer les conditions dans lesquelles il obtient un film de telle ou telle morphologie mesurant le taux de greffage obtenu, par exemple par spectroscopie d'impédance électrochimique, selon les conditions opératoires, afin de trouver la solution la mieux adaptée dans l'application qu'il fait de la présente invention.

Lorsque la couche du premier matériau est déposée suivant l'une des techniques précitées, le deuxième matériau peut être inséré au sein de cette couche formant le premier matériau conformément au procédé de l'invention. Les techniques utilisables entrant dans le cadre de la présente invention pour cette étape sont nombreuses. Les inventeurs ont toutefois noté que les techniques suivantes sont particulièrement avantageuses pour la mise en oeuvre de la présente invention.

Ainsi, selon un mode de réalisation préféré de l'invention, le deuxième matériau est inséré au sein du premier matériau au moyen d'une solution de précurseurs ioniques de ce deuxième matériau. Il peut s'agir par exemple :
- d'un bain électrolytique, permettant l'initiation de la formation du deuxième matériau au sein du premier matériau par électrodéposition tel qu'un bain de sels métalliques, adapté par exemple pour des dépôts de cuivre, de zinc, d'or, d'étain, etc. ; un bain de polymères chargés ou polyélectrolytes, etc. Le bain peut éventuellement contenir un mélange de ces précurseurs, de façon à réaliser des alliages (plusieurs précurseurs métalliques) ou des composites organométalliques (précurseurs métalliques + précurseurs organiques) ;
- d'un bain de précipitation, permettant la précipitation du deuxième matériau à partir de son précurseur sous la forme d'un sel insoluble. Là encore, le bain peut éventuellement contenir plusieurs types de précurseurs, de façon à réaliser des co-précipitations de plusieurs deuxièmes matériaux différents au sein du premier matériau.

Dans les deux cas, une étape importante consistera à assurer la pénétration des précurseurs ioniques au sein du film organique d'armature.

Cela suppose que premier matériau, par exemple un film organique, puisse recevoir ce précurseur du deuxième matériau. Si le premier matériau reçoit facilement en son sein le précurseur du deuxième matériau, les précautions suivantes ne seront pas forcément nécessaires.

En revanche, si le premier matériau reçoit moins facilement ou difficilement le précurseur du premier matériau, il peut être nécessaire de rendre possible cette insertion ou de l'améliorer. Pour cela, diverses solutions peuvent être apportées suivant l'origine de cette insertion difficile. Si l'origine de cette insertion non facilitée est un encombrement stérique dû à la conformation du premier matériau, ce qui semble le cas le plus fréquent, la solution peut consister à gonfler le premier matériau au moyen d'un solvant approprié. Dans le cas où le premier matériau est un polymère, ce solvant approprié peut être par exemple un solvant dudit polymère et/ou un solvant ou une solution « gonflant » ledit polymère.

Avantageusement, le premier matériau peut être au moins gonflé par la phase liquide contenant les précurseurs ioniques du deuxième matériau.

Par exemple lorsque le précurseur du deuxième matériau a un caractère ionique, la solution le contenant pour son insertion au sein du premier matériau est préférentiellement un liquide de permittivité diélectrique relativement élevée, ce qui exclut les solvants très apolaires.

L'art antérieur étant abondant sur l'obtention de films métalliques par électrodéposition à partir de solutions aqueuses, ainsi que sur les propriétés de solubilité (produit de solubilité) dans l'eau, les films d'armature électro-greffés qui sont gonflés par l'eau sont avantageusement appropriés dans la présente invention.

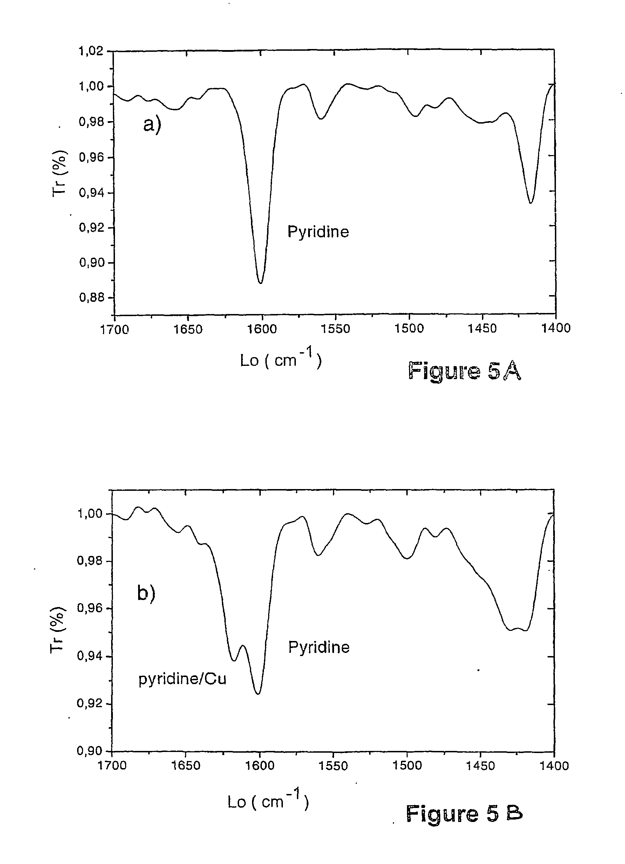

La P4VF, en tant que premier matériau par exemple, est gonflée par l'eau, comme l'indique le résultat de la figure 5A annexée : le trempage d'un film de P4VP de 100 nm d'épaisseur pendant 10 minutes dans une solution aqueuse à 5 g/l en sulfate de cuivre conduit à la formation de complexes pyridine/ion cuivrique, qui sont particulièrement visibles en infrarouge (IRRAS), ce qui montre la pénétration des ions cuivriques dans le film, alors que l'eau n'est pas un solvant, mais seulement un gonflant, de la P4VP.

Le même film, sorti de la solution de sulfate de cuivre, plongé dans l'eau, sans CuSO₄, pendant 30 minutes, ressorti, puis séché, donne le même spectre que celui de la figure 5B annexée, prouvant que les ions cuivriques peuvent même être « piégés » dans un film électro-greffé. On peut sans doute relier ce résultat au fait que le film électro-greffé contient des groupements complexants, et que les complexes pyridine/ions cuivriques formés sont plus stables que les complexes eau/ions cuivriques. Les inventeurs ont en effet noté que les ions peuvent être « sortis » du film par trempage dans une solution contenant de l'ammoniac, qui conduit à des complexes particulièrement stables avec les ions cuivriques, manifestement plus stables que les complexes pyridine/ions cuivriques initialement formés dans le film.

Le même type de pénétration dans le premier matériau, sous la forme d'un polymère électro-greffé, peut être obtenu si elle est réalisée dans un réel solvant dudit polymère : on effectue ainsi très facilement la pénétration d'ions cuivriques ou d'ions zinc (II) dans un films de P4VP ou dans un film de polyacrylonitrile (PAN) à partir d'une solution d'ions cuivrique ou zinc (II) (respectivement) dans la DMF, qui est un liquide organique dans lequel la P4VP et le PAN sont solubles (en solution).

De manière générale, les solvants organiques ayant une permittivité plus faible que celle de l'eau, ne permettent pas de préparer des solutions d'insertion aussi concentrées en ions précurseurs du deuxième matériau que cela est possible dans l'eau, car les ions y sont moins solubles que dans l'eau. Cet inconvénient peut toutefois être écarté en ayant recours à des contre-ions organiques particuliers, tels que des contre-ions organiques très solubles dans la phase organique, comme ceux utilisés dans les catalyseurs par transfert de phase ou dans les procédés d'extraction liquide/liquide : carboxylates d'acides gras (savons), alkyl sulfonates, alkyl phosphonates, alkyl phosphates etc., ce qui rend cependant la formulation plus coûteuse. Les inventeurs ont observé que la pénétration des ions précurseurs dans les films électro-greffés est en général plus lente lorsque la concentration dans le bain de trempage est plus faible.

Dans le cas par exemple où il est difficile de trouver un liquide qui soit un bon gonflant du premier matériau et dans lequel on peut également solubiliser les précurseurs du deuxième matériau, on utilisera avantageusement le troisième mode de réalisation de la présente invention. Ce troisième mode de réalisation peut être mis en oeuvre par exemple au moyen d'une solution de greffage du premier matériau sur la surface contenant à la fois le précurseur du premier matériau et le précurseur du deuxième matériau. L'électrogreffage du premier matériau sur la surface peut être réalisé de la manière exposée ci-dessus ou par toute autre technique appropriée. Une fois le greffage du premier matériau réalisé, on a un film de polymère qui contient déjà le précurseur du deuxième matériau. Ainsi, suivant ce troisième mode de réalisation, l'étape d'insertion du précurseur est effectuée simultanément à l'étape de disposition du premier matériau sur la surface du substrat. Ce mode de réalisation qui permet d'éviter une étape indépendante d'insertion du précurseur du deuxième matériau au sein du premier matériau ainsi qu'un lavage éventuel de la surface avant transformation du précurseur en deuxième matériau, peut permettre de gagner du temps dans l'application du procédé de l'invention. L'étape de transformation du précurseur du deuxième matériau en deuxième matériau peut être réalisée comme dans les autres modes de réalisation de la présente invention.

Une fois la pénétration des ions précurseurs du deuxième matériau au sein du film électro-greffé réalisé, selon l'invention, on transforme lesdits ions précurseurs du deuxième matériau insérés au sein du premier matériau en ledit deuxième matériau de manière à ce que ce deuxième matériau se forme en contact de ladite surface à revêtir et au sein dudit premier matériau disposé sur ladite surface.

Selon l'invention, cette transformation peut être réalisée dans la même solution que celle utilisée pour insérer le précurseur du deuxième matériau au sein du premier matériau, ou dans une autre solution.

Par exemple, lorsque le deuxième matériau est obtenu par électrodéposition de son précurseur au sein du premier matériau, ceci peut être réalisée au moyen d'un bain électrolytique contenant les ions précurseurs. L'électrodéposition du deuxième matériau au sein du premier matériau peut être réalisée selon un mode opératoire connu de l'homme de l'art pour la réalisation de dépôts électrolytiques. Si l'on souhaite « noyer » le film électro-greffé dans le matériau électrodéposé, il est préférable que les ions précurseurs du deuxième matériau se trouvant dans le film électro-greffé soient également présents dans la solution permettant sa transformation. En effet, lorsque le dépôt cathodique commence, il conduit à la fabrication d'une couche métallique au sein du film, d'abord par le fond, sur la surface à revêtir : les ions du film sont attirés par le fond, ce qui attire les ions de la solution dans le film pour poursuivre la croissance par dépôt du deuxième matériau au sein du film.

Selon l'invention, le bain de renfort peut donc être le même que le bain de trempage qui aura permis de remplir le film avec les ions précurseurs. Ainsi, on pourra avantageusement tremper le film « vide » constituant le premier matériau dans la solution de trempage, attendre la diffusion des ions dans le film électro-greffé, puis activer le protocole d'électrodéposition du deuxième matériau au sein du film.

Suivant ce protocole de l'invention, on obtient par exemple un dépôt de cuivre de bonne qualité, armé par un film de P4VP de 200 nm sur nickel, en réalisant les étapes suivantes : (i) trempage du film dans une solution aqueuse contenant 50 ml d'eau distillée, 11 g de [CuSO₄, 5 H₂O], 3 g de H₂SO₄ (d = 1,83), 6 mg de NaCl, pendant 30 minutes ; (ii) électrolyse pendant 15 secondes au potentiel d'équilibre, puis 1 minute à -0,5 V/(Ag⁺/Ag) (densité de courant entre 2 et 4 A/dm²), sous agitation magnétique.

Par exemple, lorsque le deuxième matériau est obtenu à partir de son précurseur par précipitation, cette dernière peut être réalisée au moyen d'un bain contenant les contre-ions assurant la précipitation d'un sel du précurseur dudit deuxième matériau. Cette procédure est bien entendu de préférence réalisée avec un bain différent de celui qui est utilisé pour le trempage, de façon à éviter la précipitation dans l'ensemble du bain de renfort.

On obtient par exemple grâce à ce protocole, un dépôt de chlorure d'argent sur une surface de nickel, armé par la P4VP, en trempant une lame de nickel portant un film de P4VP de 200 nm d'épaisseur électro-greffé dans une solution de nitrate d'argent à 5 g/l pendant 30 minutes, puis en sortant la lame, et en la trempant quelques minutes, après rinçage à l'eau désionisée, dans une solution de chlorure de sodium à 10 g/l.

La même opération, réalisée par exemple sur une lame de nickel ne portant pas de film de P4VP électro-greffé, ne conduit à aucun dépôt après traitement par la solution de NaCl.

Le principe de la formation du dépôt au sein du revêtement organique d'armature électro-greffé étant désormais détaillé, des variantes avantageuses du procédé de l'invention sont exposées ici :
- la pénétration du précurseur du deuxième matériau au sein du premier matériau, si le précurseur du deuxième matériau est sous la forme de cations précurseurs, pourra avantageusement être accélérée si elle est réalisée à un potentiel légèrement cathodique, qui permettra d'attirer les cations à l'intérieur du film. Le seul paramètre délicat est de pouvoir trouver un potentiel suffisamment cathodique pour assurer une attraction électrostatique et un courant de migration, et suffisamment peu cathodique pour effectuer la réduction de ces ions du précurseur pour former le deuxième matériau, sauf si l'on souhaite réaliser les deux étapes en même temps ;
- la transformation du précurseur du deuxième matériau lorsqu'elle consiste en un réduction d'ions précurseurs peut être avantageusement effectuée par voie chimique rédox, au lieu d'une électrodéposition, en trempant le film organique électro-greffé, constituant le premier matériau, contenant les ions précurseurs dans une solution de réducteurs chimiques. On obtient par exemple un film d'argent armé sur nickel en trempant une lame de nickel recouverte d'un film de P4VP électro-greffé de 200 nm dans une solution de nitrate d'argent à 5 g/l pendant 30 minutes, puis en la trempant quelques minutes, après rinçage à l'eau désionisée, dans une solution de glucose chauffée à 80°C. On notera cependant que ce type de protocole ne permet en général pas d'enfouir complètement la couche d'armature dans le deuxième matériau, étant donné l'absence d'ions du précurseur du deuxième matériau dans la solution pour venir compléter, par diffusion dans le film électro-greffé, les ions précurseurs consommés par le procédé de transformation du précurseur du deuxième matériau en deuxième matériau.

L'électro-greffage permet par exemple de réaliser, grâce à la formation de liaisons covalentes à l'interface surface/premier matériau, une armature particulièrement solide entre la surface et le matériau complémentaire.

Comme indiqué plus haut, on peut aussi réaliser, grâce au procédé de l'invention, un dépôt du premier matériau sur la surface conduisant à une liaison moins forte qu'un électro-greffage dudit premier matériau. Cela conduit par exemple à une armature, constituée par le premier matériau, intrinsèquement moins solide mais cependant acceptable en fonction de l'application visée.

Ceci peut être réalisé en déposant le premier matériau, par exemple sous la forme d'un revêtement organique, par des procédés plus simples que l'électro-greffage, tels que le trempage (« dip coating »), la centrifugation (« Spin coating ») ou la pulvérisation (« spray »). Ces trois modes de dépôt sont bien connus de l'homme de l'art.

On sait par exemple qu'il est possible de maîtriser l'épaisseur d'un dépôt organique par centrifugation en ajustant la concentration du polymère dans la solution de dépôt, la vitesse de rotation du dispositif et le temps d'opération. Dans le protocole par trempage, c'est la vitesse de descente, et surtout de remontée, de l'objet dans la solution du polymère qui remplace le paramètre de la vitesse de rotation de la centrifugation, et permet d'assurer un bon contrôle de l'épaisseur de polymère. Dans le protocole par pulvérisation, le contrôle d'épaisseur peut être effectué en contrôlant la taille des gouttes, leur vitesse d'éjection (via les caractéristiques géométriques de la buse et la pression du gaz vecteur, notamment) et la distance entre les buses et la surface à traiter. Ces éléments s'inscrivent parfaitement dans la mise en oeuvre de la présente invention car ils permettent d'ajuster le dépôt du premier matériau sur la surface dans le procédé de l'invention.

Les inventeurs ont par exemple obtenu un dépôt de chlorure d'argent sur une surface de nickel, armé par la P4VP, en réalisant tout d'abord un dépôt de P4VP par trempage de la lame dans une solution de P4VP à 5% en masse dans la DMF. La lame ainsi préparée a été séchée à l'étuve à 40°C sous vide primaire pendant 4h, trempée dans une solution de nitrate d'argent à 5 g/l pendant 30 minutes, puis sortie, rincée à l'eau désionisée et trempée quelques minutes dans une solution de chlorure de sodium à 10 g/l. La même opération, réalisée sur une lame de nickel ne portant pas de film de P4VP, ne conduit à aucun dépôt après traitement par la solution de NaCl. Le même type de film peut facilement être obtenu à l'aide d'un film de P4VP déposé par centrifugation, ou encore par un film de PHEMA déposé au trempé ou par centrifugation.

Les procédés d'insertion du précurseur du deuxième matériau et de sa transformation en deuxième matériau au sein du premier matériau sont les mêmes que ceux considérés aux paragraphes précédents avec les films électro-greffés. On remarquera seulement, par rapport au cas des polymères électro-greffés précités, qu'il est préférable de choisir des polymères insolubles dans ce cas. En outre, ces polymères sont de préférence choisis de manière à ce qu'il puissent être gonflés par le liquide de la solution de renfort, mais de préférence pas solubilisé afin d'éviter le lavage de la surface par la solution permettant d'y insérer le précurseur du deuxième matériau. N'importe quel polymère peut convenir a priori. Il suffit, pour qu'un polymère soit éligible, d'en connaître un solvant et un gonflant dans laquel les précurseurs du matériau de renfort sont solubles. Le solvant est utilisé pour solubiliser le polymère au moment de son application sur la surface, par exemple par centrifugation (« spin coating »), et le gonflant pour insérer le précurseur du matériau de renfort.

Les inventeurs ont par exemple obtenu un dépôt de chlorure d'argent sur une surface de nickel, armé par la P4VP, en réalisant un dépôt de P4VP rempli d'ions argent par trempage de la lame dans une solution de P4VP à 5% en masse dans la DMF, saturée en nitrate d'argent. La lame ainsi préparée a été séchée à l'étuve à 40°C sous vide primaire pendant 4h, puis trempée quelques minutes dans une solution de chlorure de sodium à 10 g/l.

Lorsque le premier matériau est un matériau à marcotter, par exemple sur une surface conductrice ou semi-conductrice, il peut être déposé par trempage ou par centrifugation à partir d'une solution de marcottage contenant ce premier matériau, de préférence macromoléculaire, et de préférence polymérique.

Comme précisé plus haut, ces deux procédés de dépôt sont bien connus de l'homme de l'art, qui sait ajuster en particulier l'épaisseur du dépôt organique, et sont utilisables dans la présente invention car ils permettent d'ajuster le dépôt du premier matériau sur la surface dans le procédé de l'invention.

Ainsi, par exemple en trempant une lame d'inox 316L dans une solution de poly(acide lactique-co-glycolique) (PLAGA, 50 :50, MM = 50-75000 g/mol, Aldrich) à 1% en masse dans le chloroforme pendant 3 minutes, on obtient un film de PLAGA homogène (mesure par profilométrie en haut et en bas de la lame) de 200 nm en retirant la lame à une vitesse de 0,05 cm/s, et un film de 400 nm en retirant la lame à une vitesse de 0,15 cm/s.

Une fois que le film à marcotter, constituant le premier matériau au sens de la présente invention, est déposé sur la surface, on réalise l'étape suivante du procédé de l'invention, c'est à dire d'insertion du deuxième matériau au sein du premier matériau. Il s'agit en fait du marcottage au sens de l'invention. Il peut être réalisé en trempant la surface portant ce film dans une solution contenant des précurseurs ioniques du deuxième matériau. Ce bain qui peut être appelé bain de renfort contiendra par exemple des cations métalliques, précurseurs du deuxième matériau qui se présentera comme une couche métallique au sein du film organique à marcotter. Cet exemple est schématisé sur la figure 2 annexée.

Il peut s'agir d'un bain tels que ceux cités ci-dessus. Une étape importante consistera, là encore, à assurer la pénétration des précurseurs ioniques au sein du film organique d'armature. Les procédés, ainsi que les solvants utilisés ici, sont les mêmes que ceux exposés ci-dessus.

Comme pour le protocole d'armature précédemment décrit, il peut être intéressant de disposer, au sein du polymère à marcotter, de groupements susceptibles de complexer les ions de la solution de renfort. Toutefois, le marcottage étant réalisé selon l'invention plutôt pour fixer un matériau organique précis sur une surface conductrice ou semi-conductrice, choisi pour ses propriétés intrinsèques, il est possible que ce matériau ne possède pas de groupements complexants. Comme illustré dans les exemples de réalisation ci-dessous, le marcottage est cependant quand même possible dans ce dernier cas grâce au procédé de l'invention.

Dans le cas par exemple où il est difficile de trouver un liquide qui soit un bon gonflant du premier matériau et dans lequel on peut également solubiliser les précurseurs du deuxième matériau, on utilisera avantageusement le troisième mode de réalisation de la présente invention. En effet, si aucun gonflant ne convient il est possible, selon l'invention, d'utiliser un solvant qui solubilise les précurseurs du deuxième matériau et qui permet aussi de réaliser le dépôt du premier matériau sur la surface. Ce troisième mode de réalisation peut être mis en oeuvre par exemple à l'aide d'une solution contenant à la fois le premier matériau, par exemple le polymère marcottable, et le précurseur du deuxième matériau, par exemple le matériau de renfort. Le dépôt du premier matériau peut être réalisé par exemple par centrifugation (« spin coating ») ou par toute autre technique appropriée indiquée dans la présente. Une fois le dépôt réalisé, on a un film de polymère qui contient déjà les précurseurs du deuxième matériau. Ainsi, suivant ce troisième mode de réalisation, l'étape d'insertion du précurseur est effectuée simultanément à l'étape de dépôt du premier matériau sur la surface du substrat. Ce mode de réalisation qui permet d'éviter une étape indépendante d'insertion du précurseur du deuxième matériau au sein du premier matériau ainsi qu'un lavage éventuel de la surface avant transformation du précurseur en deuxième matériau, peut permettre de gagner du temps dans l'application du procédé de l'invention. L'étape de construction du matériau de renfort au sein du matériau marcottable reste inchangée.

Une fois la pénétration du précurseur du deuxième matériau au sein du premier matériau effectuée, on réalise la transformation du précurseur en ledit deuxième matériau dans une solution qui permet de réaliser l'un ou l'autre des procédés précédemment mentionnés.

Par exemple :
- l'électrodéposition peut être réalisée dans un bain électrolytique ne contenant pas, de préférence, les ions précurseurs, et l'on réalise la transformation du précurseur selon un mode opératoire connu de l'homme de l'art pour la réalisation de dépôts électrolytiques. Ce mode de réalisation permet de ne pas « noyer » le film électro-greffé dans le matériau électrodéposé, comme représenté sur la figure 2. On obtient par exemple un dépôt très adhérent de PHEMA sur nickel ou sur inox 316L en réalisant les étapes suivantes : (i) trempage de la lame dans une solution à 5% en masse de PHEMA dans la DMF ; (ii) séchage de la lame au sèche-cheveux pendant 20 secondes (le film obtenu a une épaisseur de l'ordre de 200 nm) ; (iii) trempage pendant 3 minutes du film dans une solution aqueuse contenant 50 ml d'eau distillée, 11 g de [CuSO₄, 5 H₂O], 3 g de H₂SO₄ (d = 1,83), 6 mg de NaCl ; (iv) sortie de la lame, et trempage dans une solution identique à la précédente mais ne contenant pas le sulfate de cuivre, puis électrolyse pendant 15 secondes au potentiel d'équilibre, puis 30 secondes à -0,5 V/(Ag⁺/Ag) (densité de courant entre 2 et 4 A/dm²), sous agitation magnétique. La lame est finalement rincée pendant 2 minutes sous ultrasons dans la DMF. On observe un film de PHEMA sur la surface marcottée, alors qu'on ne détecte aucun film de PHEMA sur la même lame non marcottée (dépôt du PHEMA au trempé, trempage dans les solutions successives, sans électrolyse.
- la précipitation peut aussi être réalisée dans un bain contenant les contre-ions assurant la précipitation d'un sel de l'ion précurseur qui a été inséré dans le film. Cette procédure est bien entendu de préférence réalisée au moyen d'un bain différent de celui utilisé pour l'insertion du précurseur dans le premier matériau, de façon à éviter la précipitation dans l'ensemble du bain de renfort. On obtient par exemple un dépôt de P4VP adhérent sur nickel en trempant une lame de nickel dans une solution à 5% de P4VP dans la DMF, puis dans une solution de nitrate d'argent à 5 g/l pendant 3 minutes, puis en sortant la lame, et en la trempant quelques minutes, après rinçage à l'eau désionisée, dans une solution de chlorure de sodium à 10 g/l, avant rinçage sous ultrasons pendant 2 minutes dans la DMF. La même opération, réalisée sans l'étape d'insertion du précurseur du deuxième matériau dans la solution de nitrate d'argent, ne laisse aucun film de P4VP après rinçage à la DMF. Voir également l'exemple rajouté ci-dessus, où l'on réalise le dépôt d'un film de P4VP déjà truffé avec des ions argent.

Les deux variantes avantageuses du procédé de l'invention exposées ci-dessus sont également applicables ici. Pour ce qui concerne la pénétration accélérée des cations de précurseur du deuxième matériau, on pourra avantageusement contrôler la quantité de métal électrodéposé au sein du film en contrôlant la charge passant lors de électrodéposition.

Les exemples de réalisation qui suivent ont pour but d'illustrer la fixation de divers matériaux sur des surfaces conductrices ou semi-conductrices de l'électricité, et de caractériser les produits obtenus. Ils sont donnés à titre illustratif et non limitatif, en référence aux dessins annexés.

### Brève description des figures

- La figure 1 est une représentation schématique d'une fixation très adhérente de métal (matériau de renfort) sur une surface conductrice ou semi-conductrice (substrat), au moyen d'une armature constituée d'un film de polymère électro-greffé, conformément au premier mode de réalisation de la présente invention. Il s'agit par exemple de la fixation de cuivre sur or ou sur nitrure de titane, par armature à l'aide d'un film de poly-4-vinyl pyridine.
- La figure 2 est une représentation schématique du deuxième mode de réalisation de la présente invention, lorsque le premier matériau est simplement déposé sur la surface, et le deuxième matériau renforce la fixation du premier matériau sur la surface. Il s'agit par exemple du marcottage de poly-hydroxy-éthyle méthacrylate (PHEMA) sur nickel à l'aide d'un renfort par électro-déposition de cuivre.
- Les figures 3A et 3B sont des schémas des mécanismes réactionnels de l'électro-greffage de l'acrylonitrile par polarisation cathodique. La réaction de greffage correspond à la figure 3A où la croissance a lieu à partir de la surface (S). La figure 3B est la réaction chimique parasite principale qui conduit à du polymère non greffé.
- La figure 4 est une représentation schématique du premier mode de réalisation de la présente invention, lorsque le premier matériau simplement déposé sur la surface forme une armature du deuxième matériau.
- Les figures 5A et 5B sont des spectres infrarouges (IRRAS) de films de P4VP ayant une épaisseur de 100 nm sur nickel avant (a) et après (b) trempage 10 minutes dans une solution aqueuse à 5 g/l en sulfate de cuivre. Le dédoublement du pic à 1617 cm⁻¹ est caractéristique de la formation de complexes cuivre/pyridine prouvant la pénétration de la solution dans le film.

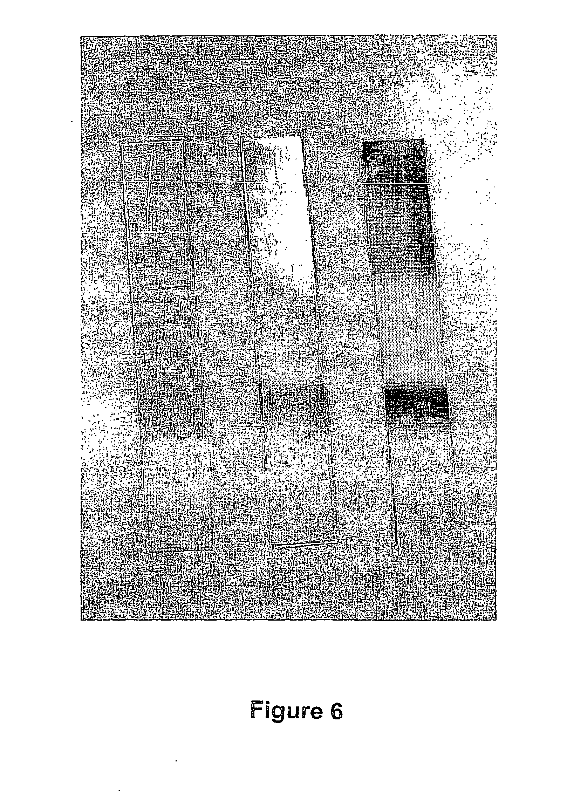

- La figure 6 est une photographie de trois lames obtenues par fixation de cuivre sur une surface d'or grâce à une armature constituée un film de P4VP électro-greffé conformément au procédé de la présente invention. Le cuivre déposé est obtenu par une électro-déposition potentiostatique de durée variable. De gauche à droite, on observe le résultat d'une électro-déposition pendant 50, 120 et 240 secondes, respectivement.

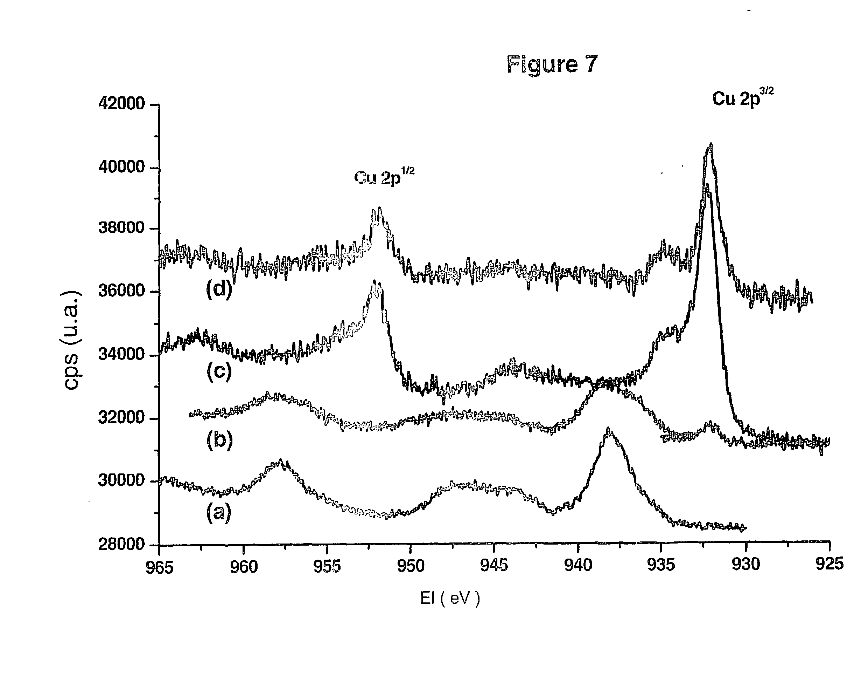

- La figure 7 rend compte des spectres de photoélectrons X (XPS) des lames de la Figure 6, dans la région des orbitales 2p du cuivre. Le spectre (a) est celui obtenu après trempage des lames d'inox recouverte du film de P4VP électro-greffé dans la solution d'ions cuivriques (voie exemple n°1) ; les spectres (b), (c) et (d) sont ceux obtenus après électro-déposition du cuivre dans, et armature par, les films de P4VP, montrant la conversion progressive des ions cuivriques du film en atomes de cuivre.

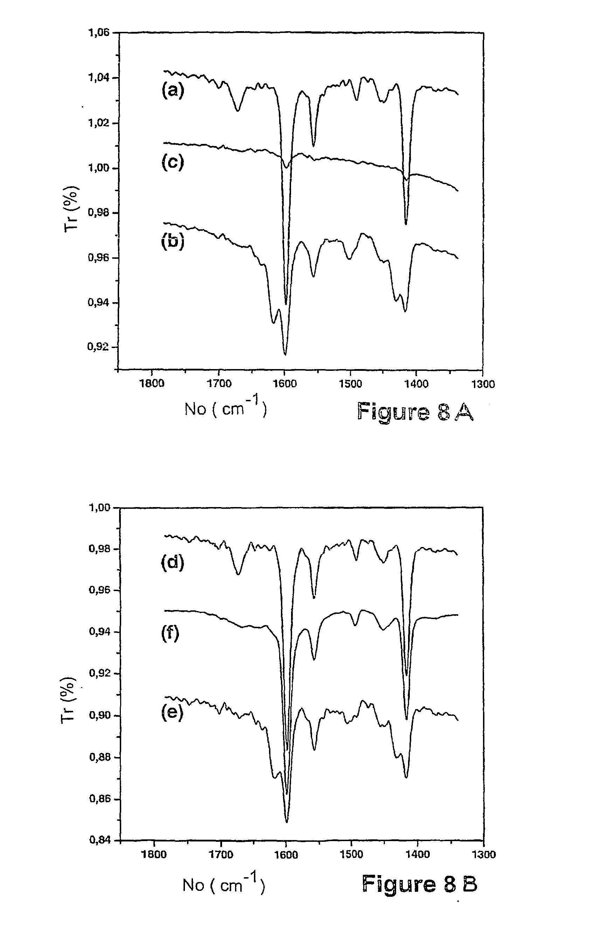

- Les figures 8A et 8B sont des spectres infrarouges de lames obtenues lorsqu'on réalise le dépôt d'un film de P4VP par marcottage au cuivre (8B(d-f)), en comparaison de celles où le marcottage n'est pas réalisé (8A(a-c)). Les spectres (a) et (d) sont identiques, et correspondent au film de P4VP déposé sur la surface d'or par centrifugation. Les spectres (b) et (d) sont obtenus après trempage de la lame ainsi recouverte du film de P4VP dans une solution concentrée en cuivre. Le spectre (c) est celui obtenu en procédant simplement aux étapes de rinçage de la lame directement après trempage dans la solution de complexation, sans procéder au marcottage : on observe que la lame a été quasiment complètement lavée. Au contraire, le spectre (f) est celui obtenu en réalisant le marcottage avant le protocole de rinçage : on observe nettement les bandes caractéristiques du film de P4VP tel que déposé à l'origine, à la différence que ce film a résisté au rinçage à la DMF pendant 2h30. Un test simple montre qu'il résiste également à un rinçage sous ultra-sons pendant 2 minutes à la DMF, ce qui lui confère une très bonne adhérence sur la surface d'or.

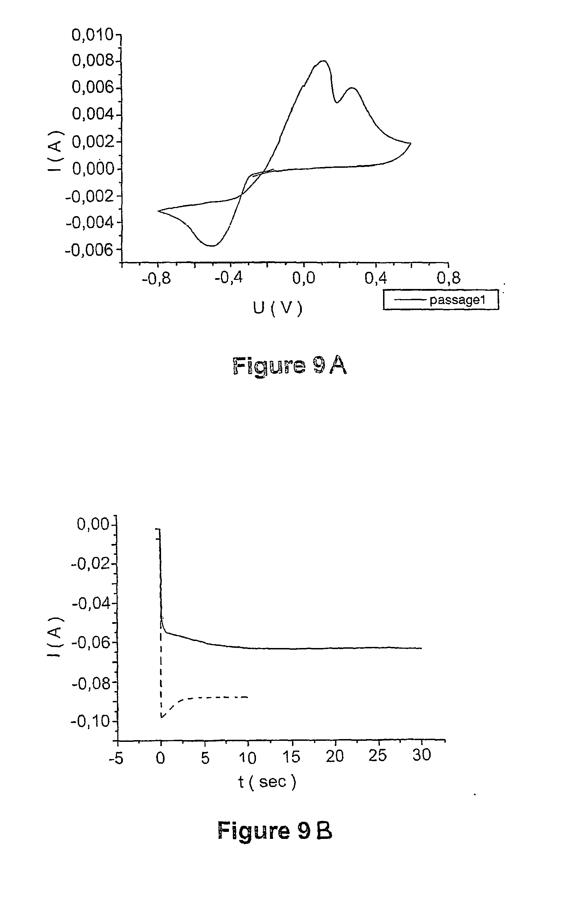

- Les figures 9A et 9B représentent respectivement un voltammogramme de la solution utilisée pour le dépôt d'ions cuivriques sur une électrode vierge, et permettant de définir le potentiel de dépôt du matériau précurseur (sels de cuivre). La figure 9B permet de comparer le courant d'électrolyse obtenu en présence d'un film de poly-hydroxyéthyl méthacrylate (PHEMA) en registré en trait continu par rapport à celui obtenu en l'absence de film, tels qu'obtenus dans l'exemple 7 ci-dessous, enregistré en traits pointillés.

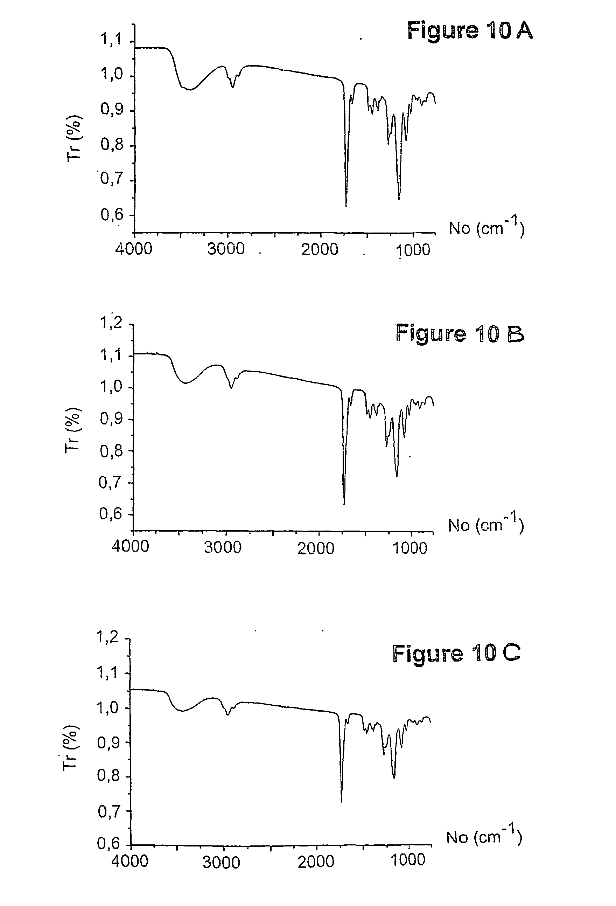

- Les figures 10A, 10B et 10C sont des spectres infrarouges (IRRAS) de films de PHEMA qui illustrent les résultats de l'exemple 7 ci-dessous. La figure 10A représente le spectre d'un film de PHEMA vierge ayant une épaisseur de 150 nm déposé sur une lame d'or. La figure 10B représente le spectre d'un film de PHEMA, ayant une épaisseur de 150 nm déposé sur une lame d'or et traité dans une solution d'ions cuivre par trempage puis par électrolyse dans les conditions de la figure 9B en trait continu . La figure 10C représente le spectre Tr (%) = f(No(cm⁻¹) d'un film de PHEMA obtenu dans les conditions décrites pour le 10B puis soumis 2 minutes aux ultra-sons dans la DMF.

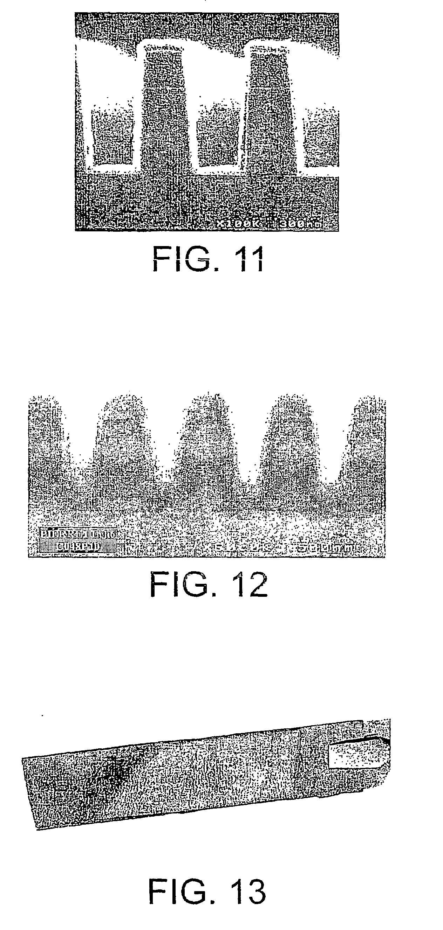

- Figure 11 : Cliché en microscopie électronique à balayage de la tranche d'un coupon montrant la formation, sur TiN, d'une couche de germination de cuivre, estimée à 10 nm environ, obtenue à partir d'un film d'aryldiazonium électro-greffé.
- Figure 12 : Cliché en microscopie électronique à balayage de la tranche d'un coupon montrant le remplissage, par du cuivre, de tranchées de 0,22 µm portant une couche de germination préalablement obtenue par électro-greffage d'un aryldiazonium métallisé par du palladium.
- Figure 13 : Cliché macroscopique d'une lame plane de silicium portant une couche de SiO2 de 400 nm et une couche de TiN de 10 nm, portant une couche de cuivre obtenue par électro-greffage à partir d'une solution de 4-VP et de précurseurs de cuivre dans la DMF. La surface de TiN a été rayé jusqu'à la silice, et on n'observe de dépôt que sur la partie ayant trempé dans le bain d'électro-greffage et qui était connectée via le TiN.

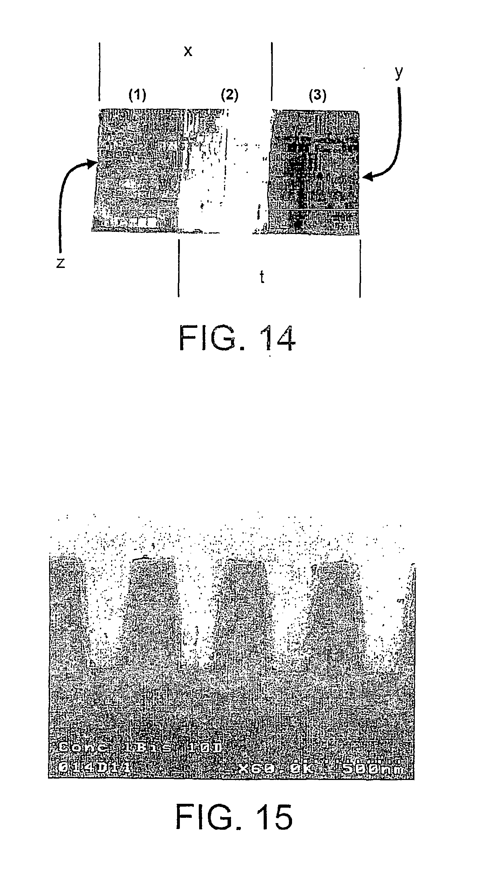

- Figure 14 : Cliché d'un coupon structuré après couche de germination obtenue par électro-greffage de 4-VP et ECD : (1) zone avec couche de germination ; (2) zone avec couche de germination + ECD ; (3) zone avec barrière seule.
- Figure 15 : Cliché en microscopie électronique à balayage de la tranche d'un coupon montrant le remplissage, par du cuivre, de tranchées de 0,22 µm portant une couche de germination préalablement obtenue par électro-greffage à partir d'une solution de 4-VP et de précurseurs de cuivre.

Sur ces figures, « S » représente la surface qui doit être ou qui est revêtue au moyen du procédé de l'invention ; « 1M » : le premier matériau au sens de la présente invention ; «2M» : le deuxième matériau au sens de la présente invention ; « P2M » : le précurseur du deuxième matériau au sens de la présente invention ; « tr (%) » : la transmission en % ; « No (cm⁻¹) » : le nombre d'onde en cm⁻¹ ; « cps (u.a.) » : nombre de coups par seconde, en unités arbitraires ; « El (eV) » : l'énergie de liaison en eV ; « I (A) » : l'intensité en ampères ; « U (V) » la tension en Volts ; « t (s) : le temps en secondes.

### EXEMPLES

### Exemple n°1 : Fixation de cuivre sur une surface d'or par armature grâce à un film de P4VP électro-greffé

Cet exemple illustre la fixation très adhérente de cuivre sur une surface d'or, au moyen d'une armature constituée un film de poly-4-vinyl pyridine (P4VP) électro-greffé. La figure 1 est une représentation schématique de cet exemple conforme à la présente invention.

On réalise tout d'abord sur une lame d'inox 316L un film électro-greffé de P4VP de 30 nm d'épaisseur en soumettant la surface, plongée dans une solution à 40% en volume de 4-vinyl pyridine dans la DMF, en présence de 5.10⁻² mol/l de TEAP, à 50 balayages voltammétriques de -0,7 à -2,9 V/(Ag⁺/Ag) à 200 mV/s.

La lame ainsi traitée est rincée à la DMF, séchée sous courant d'argon, puis trempée pendant 25 minutes dans une solution de 10 g de sulfate de cuivre [CuSO₄, 5 H₂O] dans 200 ml d'eau désionisée. La lame est ensuite rapidement rincée avec quelques jets d'eau désionisée, puis plongée dans la DMF. On la soumet alors à une polarisation cathodique à un potentiel constant de -1,15 V/ECS pendant un temps T.

Trois lames préparées de la même façon sont ainsi traitées, à des temps de polarisation respectivement de T = 50 (L1), 120 (L2) et 240 (L3) secondes.

Les lames sont ensuite rincées à la DMF sous ultrasons pendant 2 minutes, séchée sous courant d'argon. Elles sont représentées sur la figure 6 annexée.

Elles sont analysées en spectroscopie de photoélectrons. Les résultats de cette analyse sont représentés sur la figure annexée. Sur cette figure spectre de la lame (a) est celui obtenu, dans la zone des orbitales 2p du cuivre, juste après l'étape de trempage dans la solution d'ions cuivriques, i.e. avant dépôt du matériau de renfort dans le film de P4VP. On y observe, respectivement vers 938 et 958 eV, les raies 2p^{1/2} et 2p^{3/2} des ions cuivriques. Le spectre (b) est celui obtenu après une polarisation de 50 s, qui montre, après rinçage, essentiellement les ions cuivriques, et un très léger épaulement vers 932 eV, caractéristique des niveaux 2p^{3/2} du cuivre métallique. Les spectres (c) et (d) sont ceux obtenus respectivement après un dépôt du matériau de renfort suite à une polarisation de 120 et 240 s : ils montrent nettement la disparition des pics des niveaux 2p des ions cuivriques, au profit de ceux des niveaux 2p du cuivre métallique, montrant la formation du matériau de renfort sur la surface d'inox 316L, au sein du film de P4VP.

Comme le montrent les images de la figure 6 annexée, on observe nettement la formation d'un dépôt de cuivre sur la surface pour les lames ayant subi une polarisation suffisante. Ce dépôt est adhérent. Il résiste en particulier à un rinçage de 2 minutes sous ultra-sons dans la DMF.

En comparaison, un dépôt de cuivre réalisé dans les mêmes conditions mais en l'absence d'un film de P4VP conduit à un dépôt poudreux non adhérent, quasiment entièrement éliminé par le rinçage à la DMF sous ultrasons.

### Exemple n°2 : Fixation de cuivre sur une surface d'or par armature grâce à un film de P4VP électro-greffé (II)

On reconduit l'expérience de l'exemple n°1, mais en utilisant une solution électrodéposition différente, traditionnelle en galvanoplastie au bain mort aussi bien qu'au tonneau, assurant un dépôt de cuivre brillant de meilleure qualité. Cet exemple permet d'illustrer la compatibilité de l'armature avec les procédés de galvanoplastie, et donc de bénéficier d'un renfort de l'interface cuivre/or tout en déposant bien le matériau d'intérêt que constitue le cuivre selon le même procédé que d'habitude.

Pour cela, la lame d'or recouverte d'un film de P4VP électro-greffé est trempée dans une solution aqueuse contenant 50 ml d'eau distillée, 11 g de [CuSO₄, 5 H₂O], 3 g de H₂SO₄ (d = 1,83), 6 mg de NaCl, pendant 30 minutes, puis électrolysée dans la solution pendant 15 secondes au potentiel d'équilibre, puis 3 minutes à -0,5 V/(Ag⁺/Ag) (densité de courant entre 2 et 4 A/dm²), sous agitation magnétique.

On obtient un dépôt de cuivre uniforme très brillant, présentant une bonne adhérence sur la surface, puisqu'il résiste au rinçage sous ultrasons dans la DMF pendant 2 minutes, alors que le même dépôt est altéré dans les mêmes conditions de rinçage sans armature préalable.

### Exemple n°3 Fixation de nickel sur une surface d'or par armature grâce à un film de P4VP électro-greffé

On réalise la même expérience que dans l'exemple n°2, mais en utilisant une solution de renfort d'ions nickel (II), précurseurs d'un dépôt de nickel métallique, contenant 50 ml d'eau désionisée, 12,5 g de sulfate de nickel, 3,25 g de chlorure de nickel et 2 g d'acide borique.

Une lame d'or recouverte d'un film de P4VP électro-greffé de 30 nm d'épaisseur est trempée dans la solution ainsi préparée pendant 30 minutes, puis électrolysée dans la solution ci-dessus pendant 15 secondes au potentiel d'équilibre, puis 3 minutes à une densité de courant cathodique entre 2 et 4 A/dm², sous agitation magnétique.

On obtient un dépôt de nickel, présentant une bonne adhérence sur la surface, puisqu'il résiste au rinçage sous ultrasons dans la DMF pendant 2 minutes, alors que le même dépôt est altéré dans les mêmes conditions de rinçage sans armature préalable.

### Exemple n°4 : Fixation de cuivre sur une surface d'or par armature grâce à un film de PHEMA électro-greffé

Cet exemple illustre la réalisation d'une armature par un film électro-greffé de PHEMA. A la différence de l'exemple n°2, ce polymère ne contient pas de groupements fonctionnels pouvant agir comme agents complexants vis-à-vis des ions cuivriques de la solution de renfort.

Sur une lame d'or analogue à celles des exemples précédents plongée dans une solution à 0,4 mol/l d'hydroxyéthyl méthacrylate dans la DMF, en présence de 5.10⁻² mol/l de TEAP (Tétra Ethyl Ammonium Perchlorate), on réalise un film électro-greffé de poly-hydroxyéthyl méthacrylate (PHEMA) d'environ 40 nm en effectuant 10 balayages voltammétriques de +1,0 à -3,0 V/(Ag⁺/Ag) à 50 mV/s.

La lame ainsi obtenue est trempée dans une solution aqueuse contenant 50 ml d'eau distillée, 11 g de [CuSO₄, 5 H₂O], 3 g de H₂SO₄ (d = 1,83), 6 mg de NaCl, pendant 30 minutes, puis électrolysée dans la solution pendant 15 secondes au potentiel d'équilibre, puis 3 minutes à -0,5 V/(Ag⁺/Ag) (densité de courant entre 2 et 4 A/dm²), sous agitation magnétique.

On obtient un dépôt de cuivre uniforme très brillant, présentant une bonne adhérence sur la surface, puisqu'il résiste au rinçage sous ultrasons dans la DMF pendant 2 minutes, alors que le même dépôt est altéré dans les mêmes conditions de rinçage sans armature préalable.

### Exemple n°5 : Fixation de cuivre sur une surface d'inox 316L par armature grâce à un film de PHEMA électro-greffé

On illustre ici la réalisation d'une armature avec un film de polymère électro-initié à partir de sels de diazonium, précurseurs de polymérisation radicalaires, et non à partir d'un film de polymère strictement électro-greffé à partir d'une solution ne contenant que des monomères vinyliques. On observe une armature de bonne qualité, même si elle n'est pas réalisée avec un film électro-greffé. En outre, on observe la réalisation d'une armature sur un métal de ceux utilisés dans les exemples précédents.

On réalise la formation d'un film de 300 nm de PHEMA sur inox 316L en réalisant 40 balayages voltammétriques de -0,6 à -3,0 V/(Ag⁺/Ag) à 100 mV/s sur une surface d'inox 316L plongée dans une solution à 3,5 mol/l d'hydroxyéthyl méthacrylate (HEMA) dans la DMF, en présence de 2,5.10⁻² mol/l de NaNO₃, et 10⁻² mol/l de tétrafluoroborate de 4-nitrophényl diazonium.

La lame ainsi obtenue est trempée dans une solution aqueuse contenant 50 ml d'eau distillée, 11 g de [CuSO₄, 5 H₂O], 3 g de H₂SO₄ (d = 1,83), 6 mg de NaCl, pendant 30 minutes, puis électrolysée dans la solution pendant 15 secondes au potentiel d'équilibre, puis 5 minutes à -0,5 V/(Ag⁺/Ag) (densité de courant entre 2 et 4 A/dm²), sous agitation magnétique.

On obtient un dépôt de cuivre uniforme très brillant, présentant une bonne adhérence sur la surface, puisqu'il résiste au rinçage sous ultrasons dans la DMF pendant 2 minutes, alors que le même dépôt est altéré dans les mêmes conditions de rinçage sans armature préalable.

### Exemple n°6 : Fixation de P4VP sur une surface d'or par marcottage électrochimique par du cuivre

Cet exemple illustre la fixation d'un polymère sur une surface métallique par marcottage, le polymère étant simplement déposé par électrodéposition sur la surface sur laquelle on désire le fixer.

On réalise ainsi, par électrodéposition à partir d'une solution à 5% en masse de P4VP dans la DMF, un dépôt de P4VP d'environ 100 nm sur une lame d'or analogue à celle des exemples précédents. La lame ainsi traitée est séchée au sèche-cheveux, puis trempée pendant 25 minutes dans une solution contenant 10 g de sulfate de cuivre dans 200 ml d'eau désionisée. La lame est ensuite rincée à l'eau désionisée, puis plongée dans un bain d'électrolyse contenant 2 g de sulfate de cuivre et 3 g de NaCl dans 500 ml d'eau désionisée. La lame est ensuite soumise à 10 balayages voltammétriques entre 0 et -0,5 V/ECS à 200 mV/s, sortie, rincée à l'eau désionisée, puis décomplexée des ions cuivriques en excès par un trempage pendant 20 minutes dans une solution aqueuse d'ammoniac à 10%, et finalement rincée par trempage pendant 2h30 dans une solution de DMF.

La figure 8 montre les spectres infrarouge des lames obtenues aux différentes étapes ci-dessus, dans la zone des modes de vibration du cycle pyridine du polymère. Les spectres (a) et (d) sont identiques, et correspondent au film de P4VP déposé sur la surface d'or par électrodéposition. La bande à 1600 cm⁻¹ est caractéristique du groupement pyridine. Les spectres (b) et (d) sont obtenus après trempage de la lame recouverte du film de P4VP dans la solution concentrée en cuivre : on observe un dédoublement du pic précédent, avec apparition d'un second pic vers 1620 cm⁻¹, caractéristique du complexe formé entre les cycles pyridine et les ions cuivriques. Le spectre (c) est celui obtenu en procédant simplement aux étapes de rinçage de la lame directement après trempage dans la solution de complexation, sans procéder au marcottage : on observe que la lame a été quasiment complètement lavée. Au contraire, le spectre (f) est celui obtenu en réalisant le marcottage avant le protocole de rinçage : on observe nettement les bandes caractéristiques du film de P4VP tel que déposé à l'origine, à la différence que ce film a résisté au rinçage à la DMF pendant 2h30. Un test simple montre qu'il résiste également à un rinçage sous ultrasons pendant 2 minutes à la DMF, ce qui lui confère une très bonne adhérence sur la surface d'or.

### Exemple n°7 : Fixation de PHEMA sur une surface de nickel par marcottage électrochimique par du cuivre

Cet exemple illustre le marcottage d'un polymère qui ne possède pas de groupements fonctionnels complexants des ions précurseurs du bain de renfort. On observe que le marcottage peut également être réalisé dans ces conditions.

On réalise tout d'abord un film de PHEMA d'environ 200 nm d'épaisseur par centrifugation sur une lame de nickel d'une solution de PHEMA à 5% dans la DMF, puis séchage au sèche-cheveux.

La lame ainsi obtenue est partiellement trempée dans une solution aqueuse contenant 50 ml d'eau distillée, 11 g de [CuSO₄, 5 H₂O], 3 g de H₂SO₄ (d = 1,83), 6 mg de NaCl, pendant 3 minutes, puis électrolysée dans la solution pendant 15 secondes au potentiel d'équilibre, puis 30 secondes à -0,5 V/(Ag⁺/Ag) (densité de courant entre 2 et 4 A/dm²), sous agitation magnétique. La Figure 9B compare le courant d'électrolyse obtenu en présence du film de PHEMA (trait continu) par rapport à celui obtenu en l'absence du film (trait discontinu). Lorsque l'électrolyse est terminée, la lame est rincée, tout d'abord simplement à la DMF, puis 2 minutes sous ultrasons dans la DMF.

On observe la disparition totale du film de PHEMA dans la partie non traitée, alors qu'on récupère un film de PHEMA marcotté au cuivre, très adhérent, dans la partie traitée. Le spectre IRRAS dans cette zone révèle que le polymère a exactement la structure du film de PHEMA de départ. Ces résultats sont représentés sur les figures 10A à 10C annexées.

### Exemple n°8 : Fixation de PAN sur une surface de nickel par marcottage électrochimique par du cuivre

Cet exemple illustre la fixation de polyacrylonitrile (PAN) sur or par marcottage par du cuivre.

La particularité du PAN est qu'il s'agit d'un polymère particulièrement hydrophobe, qui n'est ni dissous ni gonflé par l'eau. Le marcottage est ici réalisé dans une solution d'électrolyse contenant 10% de DMF, qui est un solvant du PAN.

On procède comme dans l'exemple n°7, en réalisant un dépôt de PAN de 200 nm sur une lame de nickel par centrifugation à partir d'une solution de PAN à 5% dans la DMF.

Les étapes de marcottage et de rinçage sont strictement analogues à celles de l'exemple n°7, mis à part que l'on rajoute 10% de DPMF au mélange électrolytique.

On observe par IRRAS la présence d'un film de PAN de 40 nm d'épaisseur, ce qui indique qu'une partie du film a été dissoute, probablement à l'étape de rinçage, le marcottage ayant été insuffisant.

La même expérience réalisée avec une solution de marcottage à 20% en DMF permet en effet d'obtenir un film d'environ 100 nm.

### Exemple n°9 : Fixation de chlorure d'argent sur une surface d'or par armature à l'aide d'un film de P4VP

L'utilisation d'un film de P4VP électro-greffé comme armature d'un dépôt obtenu par précipitation est illustrée ici.

On réalise un film de P4VP d'environ 30 nm d'épaisseur sur une lame d'or, selon le protocole de l'exemple n°1. La lame ainsi obtenue est trempée dans une solution de nitrate d'argent à 5 g/l pendant 30 minutes, rincée rapidement à l'eau désionisée, puis trempée quelques minutes sous agitation dans une solution de chlorure de sodium à 10 g/l.

La formation d'un dépôt de chlorure d'argent adhérent, résistant au rinçage à l'eau et à 2 minutes de rinçage sous ultrasons dans la DMF est observée.

La même opération, réalisée sur une lame d'or ne portant pas de film de P4VP électro-greffé, ne conduit à aucun dépôt après traitement par la solution de NaCl.

### Exemple n°10 : Fixation de cuivre sur une surface d'inox 316L par armature grâce à un film de Poly-ε-caprolactone électro-greffé

Cet exemple illustre la possibilité d'armer un film métallique avec un film électro-greffé dont les précurseurs sont des molécules cycliques clivables par attaque nucléophile ou électrophile, en l'occurrence 1-ε-caprolactone.

On trempe une lame d'inox 316L, identique à celle des exemples précédents, dans une solution à 5 mol/l d'ε-caprolactone dans la DMF, contenant 10⁻² mol/l de tétrafluoroborate de 4-nitrophényl diazonium et 2,5.10⁻² mol/l de nitrate de sodium (NaNO₃). Cette lame sert d'électrode de travail dans un montage à 3 électrodes, et subit 40 balayages voltammétriques à 100 mV/s de son potentiel d'équilibre (- 0,147 V/(Ag⁺/Ag)) jusqu'à - 2,8 8 V/(Ag⁺/Ag). Après rinçage de la lame à l'acétone puis à l'eau, on observe la formation d'un film de 100 nm d'épaisseur présentant une intense bande IR à 1739 cm⁻¹, caractéristique de la poly-ε-caprolactone.

Le film ainsi obtenu est utilisable comme armature pour le dépôt d'une couche de cuivre, selon les mêmes protocoles que ceux décrits dans les exemples n°1 et 2.

### Exemple n°11 : Fixation de cuivre sur une surface de fer par armature grâce à un film obtenu à partir de tétrafluoroborate de 4-carboxy benzènediazonium.

Cet exemple illustre l'utilisation de sels de diazonium porteurs de groupements complexants comme précurseurs du premier matériau, ainsi que la construction d'un film métallique adhérent sur la base de l'armature ainsi construite.

On trempe une lame de fer dans une solution à 10⁻² mol/l de tétrafluoroborate de 4-carboxy benzènediazonium et 5.10⁻³ mol/l de TEAP. Cette lame sert d'électrode de travail dans un montage à 3 électrodes, et subit 5 balayages voltammétriques à 200 mV/s de son potentiel d'équilibre (≈ + 0,3 V/(Ag⁺/Ag)) jusqu'à - 1,5 V/(Ag⁺/Ag). Après rinçage de la lame à l'acétone puis à l'eau, on observe la formation d'un film de 20 nm d'épaisseur environ, présentant d'intenses bandes IR à 3235 et 1618 cm⁻¹, caractéristiques de la modification de la surface par des groupements carboxyphényl.

Le film ainsi obtenu est utilisable comme armature pour le dépôt d'une couche de cuivre, selon les mêmes protocoles que ceux décrits dans les exemples n°1 et 2.

On observe en effet qu'un traitement analogue à celui de l'exemple n°2 permet d'obtenir un film de cuivre métallique résistant à un traitement sous ultra-sons de 2 minutes dans la DMF.

### Exemples supplémentaires

### Exemple n°12 :

Dans cet exemple particulier, on illustre la formation complète d'une couche de germination (« seed-layer ») complète par électro-greffage d'une couche organique, insertion de précurseurs de cuivre dans cette couche, réduction des précurseurs pour donner une couche de cuivre métallique de germination hyperconforme et adhérente sur une surface de TiN, et son utilisation pour le remplissage de tranchées dans une structure interconnectée de type Damascene. La couche de germination de cuivre n'est pas adhérente en l'absence de la couche électro-greffée.

Les substrats sont constitués d'éprouvettes de silicium de 2x4 cm² recouvertes d'une couche d'oxyde de silicium (diélectrique) et d'une couche de 10 nm de TiN MOCVD en tant que barrière à la diffusion du cuivre. Ces substrats sont structurés, et présentent des tranchées de 200 nm de large, espacées de 200 nm, et profondes de 400 nm environ. Aucun traitement spécifique de nettoyage ou de surface n'a été réalisé avant l'électrogreffage. Les expériences n'ont pas été réalisées dans des conditions de salle blanche.

On réalise un film électro-greffé à partir d'une solution de tétrafluoroborate d'aryl diazonium substitué par des groupements ammonium dans l'acétonitrile, en présence de perchlorate de tétraéthyl-ammonium (TEAP) comme électrolyte support.

L'électrogreffage est réalisé à potentiel imposé dans un montage à 3 électrodes. La surface de TiN est utilisée comme électrode de travail (connexion à l'aide d'une pince crocodile), la contre-électrode est une surface de graphite, l'électrode de référence est une électrode Ag⁺/Ag, connectées sur un potentiostat EGG modèle 283 (Princeton Applied Research).

Comme pour les exemples précédents, on observe que le film électro-greffé est hyperconforme à la surface d'origine, et d'une épaisseur homogène d'environ 40 nm.

Sur la couche électro-greffée, on réalise l'insertion de précurseurs métalliques de la façon suivante : les lames de TiN portant les films électro-greffés sont trempées dans une solution contenant des ions palladium (Pd(II)). On observe que le palladium s'insère dans les films grâce à la complexation par les groupements amine présents dans les films électro-greffés. Les lames sont ensuite traitées par du DiMéthyl Amino Borane (DMAB) pour réduire la palladium à l'état métallique au sein du film. Les lames ainsi traitées sont trempées dans une solution de cuivre electroless : on observe un dépôt uniforme d'une très fine couche de cuivre, catalysée par les agrégats métalliques de palladium présents au sein du film électro-greffé. Sur le substrat TiN structuré, une observation au microscope électronique à balayage à haute résolution permet de constater que la couche de cuivre est - tout comme la couche électro-greffée d'origine - hyperconforme, et d'une épaisseur homogène d'environ 20 nm (figure 11 annexée).

L'électrodéposition de cuivre est ensuite réalisée sur la couche de germination ainsi obtenue en utilisant une solution de sulfate de cuivre dans l'acide sulfurique, dans des conditions galvanostatiques à environ 7 mA/cm². On observe rapidement la formation d'un dépôt uniforme de cuivre sur la surface préalablement traitée.

Le substrat est ensuite clivé, et l'on examine la tranche de la zone fracturée au microscope électronique à balayage à haute résolution. On observe un parfait remplissage des tranchées par le cuivre avec très peu de trous (« voids »), la couche de germination ayant parfaitement joué son rôle (Figure 12).

### Exemple n°13 :

Dans cet exemple, on illustre la formation complète d'une couche de germination (« seed-layer ») par électro-greffage à partir d'un mélange de monomères vinyliques et de précurseurs de cuivre, dans un seul et même bain, et son utilisation pour le remplissage de tranchées dans une structure interconnectée de type Damascene. La couche de germination est hyperconforme et très adhérente à la surface de TiN, alors qu'elle n'est même pas obtenue en l'absence des précurseurs d'électro-greffage.

Les substrats sont des coupons de silicium plans de 2 x 4 cm², recouvert d'une couche de 400 nm de SiO₂ et d'une couche de 10 nm de TiN obtenue par MOCVD. De même que précédemment, aucun traitement spécifique de nettoyage ou de surface n'a été réalisé avant l'électrogreffage. Les expériences n'ont pas été réalisées dans des conditions de salle blanche.

On réalise un film électro-greffé sur ces substrats en les utilisant comme électrode de travail dans un montage à trois électrodes analogue à celui de l'exemple précédent. La solution d'électro-greffage est une solution de 4-vinyl pyridine et de bromure cuivreux dans la diméthyl formamide, en présence de perchlorate de tétraéthyl-ammonium (TEAP) comme électrolyte support. Les coupons sont trempés aux deux tiers de leur hauteur dans le bain d'électro-greffage, et le contact sur ces substrats est obtenu à l'aide d'une pince crocodile qui ne trempe pas dans le bain.

Des résultats spectaculaires sont obtenus : on observe une métallisation uniforme (les mesures au ménisque et à 5 cm du ménisque sont identiques, à la précision d'un microscope à force atomique (AFM)), même à quelques centimètres de l'électrode de contact.

On réalise ensuite une expérience complémentaire où le substrat est préalablement rayé horizontalement à un cinquième de sa hauteur à partir du bas environ, suffisamment profondément pour atteindre la couche de SiO₂ sous-jacente. Le coupon ainsi rayé est trempé dans le bain d'électro-greffage, rayure en bas, de sorte que la rayure est dans la solution. Le coupon est - comme précédemment - trempé aux deux tiers de sa hauteur et le contact (pince) ne trempe pas dans le bain.

En réalisant l'électro-greffage en conditions voltammétriques comme précédemment, on observe un dépôt uniforme de cuivre depuis le ménisque jusqu'à la rayure, mais rien entre la rayure et le bas de la lame : la partie de la surface TiN qui n'est plus électriquement connectée n'est pas recouverte. Ceci confirme que la croissance est bien électriquement activée, et que le dépôt n'est pas obtenu par un procédé de chimisorption sans courant (figure 13 annexée).

De même que sur le substrat plan sans rayure, des mesures d'épaisseur par AFM révèlent une grande uniformité du dépôt de cuivre, et donc une très faible sensibilité à la chute ohmique du substrat TiN semi-conducteur : même en présence du précurseur de cuivre, le mécanisme de croissance a les caractéristiques d'une réaction électro-initiée de l'électro-greffage.

En outre, les mêmes tentatives sans précurseur organique (4-vinyl pyridine) n'ont pas montré de dépôt métallique direct sur la barrière de TiN, à part au niveau du ménisque, ce qui est attribué aux effets connus de la chute ohmique du substrat.

Il doit être noté toutefois que les courants de mesure sont rapidement beaucoup plus élevés (de l'ordre de plusieurs mA) que ce qui était attendu d'un simple procédé d'électro-initiation. La majorité du courant traversant l'électrode correspondrait à la réduction des ions cuivreux en cuivre métallique sur la seed-layer naissante qui est formée dans les premiers instants. Les courants résiduels dus aux réactions d'électro-greffage ne sont probablement pas détectables lorsque la croissance du cuivre - au-delà de la seed-layer - est en marche.

Des tests complémentaires ont été enfin réalisés sur des échantillons comportant des motifs (tranchées de 0,22 µm de large, espacées de 0,22 µm et profondes de 0,4 µm), pour étudier les propriétés morphologiques des dépôts. Les mêmes conditions voltammétriques sont appliquées, dans les mêmes bains et selon le même montage. On observe - là encore - un dépôt macroscopique uniforme de cuivre.

Les coupons sont trempés aux deux tiers dans le bain, si bien que le dépôt de seed-layer est obtenu sur deux tiers du coupon, le dernier tiers étant du TiN non traité.

Des observations en microscopie électronique à balayage (SEM) sur les zones traitées montrent clairement un film métallique sur la couche barrière, qui est parfaitement continu et, de manière très intéressante, conforme à la surface. Ce résultat clé est en ligne avec la haute conformité obtenue avec une couche électrogreffée seule.

Ces couches de germination ont été utilisées pour initier un dépôt électrochimique (ECD) de cuivre à partir d'un bain commercial. A cet effet, on prend un contact électrique sur la partie précédemment électro-greffée des échantillons. Ainsi, au cours du dépôt de cuivre par ECD, l'échantillon a été renversé, et la zone de celui-ci qui n'a pas été antérieurement électrogreffée est exposée au bain d'électro-dépôt chimique du cuivre.

Après électrodéposition de cuivre, l'aspect des échantillons est très intéressant : une jolie couche de métallisation de cuivre uniforme est observée sur le tiers central du coupon, c'est-à-dire sur la surface précédemment électro-greffée de l'échantillon, alors qu'aucun cuivre n'est déposé sur la couche barrière TiN. De plus, comme précédemment, c'est sur le tiers supérieur de la lame - électro -greffé - que le contact a été pris, ce contact ne trempant pas dans le bain d'ECD et étant situé à plus d'un cm du ménisque : la couche de germination a donc été suffisamment continue et conductrice pour permettre le dépôt de cuivre ECD sur la zone traitée trempant dans le bain (figure 14 annexée). Sur la figure 14, « x » représente la partie de la lame où est effectué l'électrogreffage ; « y » représente la zone de contact pour l'élèctrogreffage ; « z » représente le contact pour l'électrodéposition ; et « t » représente la partie de la lame sur laquelle il y a électrodéposition.

D'un point de vue microscopique, l'examen du remplissage du cuivre a été réalisé par SEM sur des coupes d'échantillon réalisées par nano-usinage (FIB : faisceau d'ions focalisés, « Focused Ion Beam » en anglais). On observe un remplissage satisfaisant des tranchées, même si quelques vides apparaissent. Les inventeurs pensent que dans des conditions plus favorables (salle blanche, contrôle amélioré des surfaces chimiques et de barrière, etc. les performances de remplissage des tranchées peuvent être nettement améliorées (figure 15 annexée).

### Liste de références

**[1]** E.P. Plueddmann, « Fundamentals of Adhesion », L.H. Lee (Ed.), p.279, Plenum Press, New-York (1990).
**[2]** Z. Mekhalif, J. Riga, J.-J Pireaux and J. Delhalle, *Langmuir,* **13**, 2285 (1997).
**[3]** V. Huc, J.P. Bourgoin, C. Bureau, F. Valin, G. Zalczer and S. Palacin, « Self-assembled mono- and multi-layers on gold from phenyl-diisocyanides and ruthenium phtalocyanines », *Journal of Physical Chemistry B,* **103,** 10489 (1999).
**[4]** WO-A-9844172.
**[5]** EP-A-665 275.
**[6]** C. Jérôme et al., *Chem. Mater.,* 2001, **13**, 1656.
**[7]** US 4 975 475.
**[8]** US 6 171 661.

## Revendications

1. Procédé de revêtement d'une surface par un premier et un deuxième matériaux comprenant les étapes suivantes :
- disposer sur ladite surface le premier matériau,
- insérer au sein du premier matériau, un précurseur du deuxième matériau, en même temps que ou après l'étape consistant à disposer sur ladite surface ledit premier matériau,
- transformer ledit précurseur du deuxième matériau inséré au sein du premier matériau en ledit deuxième matériau de manière à ce que ce deuxième matériau se forme sur ladite surface à revêtir et au sein dudit premier matériau disposé sur ladite surface.

2. Procédé selon la revendication 1, dans lequel la surface est minérale ou organique.

3. Procédé selon la revendication 1, dans lequel le premier matériau est un matériau organique et le deuxième matériau est un matériau minéral.

4. Procédé selon la revendication 3, dans lequel le premier matériau est une macromolécule organique ou un polymère, et le deuxième matériau est un matériau minéral.

5. Procédé selon la revendication 1, dans lequel le premier matériau est obtenu à partir d'un précurseur chimique de celui-ci choisi dans le groupe constitué des monomères vinyliques, des sels de diazonium fonctionnalisés ou non, des sels de sulfonium fonctionnalisés ou non, des sels de phosphonium fonctionnalisés ou non, des sels d'iodonium fonctionnalisés ou non, et de leurs mélanges.

6. Procédé selon la revendication 5, dans lequel le premier matériau est obtenu à partir d'un ou de plusieurs monomère(s) vinylique(s) activé(s), de structure (I) suivante : 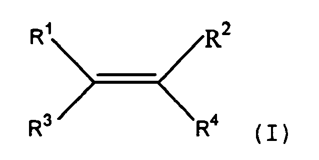 dans laquelle R¹, R², R³, R⁴, sont des groupements organiques choisis indépendamment les uns des autres dans le groupe constitué des fonctions organiques suivantes : hydrogène, hydroxyle, amine, thiol, acide carboxylique, ester, amide, imide, imido-ester, halogénure d'acide, anhydride d'acide, nitrile, succinimide, phtalimide, isocyanate, époxyde, siloxane, benzoquinone, benzophénone, carbonyle-diimidazole, para-toluène sulfonyle, para-nitrophényl chloroformiate, éthylénique, vinylique, et aromatique.

7. Procédé selon la revendication 6, dans lequel, au moins un de R¹, R², R³, R⁴ est un groupement fonctionnel pouvant complexer des cations.

8. Procédé selon la revendication 5, dans lequel le premier matériau est un polymère obtenu par polymérisation d'un monomère vinylique choisi dans le groupe constitué des monomères vinyliques comme l'acrylonitrile, le méthacrylonitrile, le méthacrylate de méthyle, le méthacrylate d'éthyle, le méthacrylate de butyle, le méthacrylate de propyle, le méthacrylate d'hydroxyéthyle, le méthacrylate d'hydroxypropyle, le méthacrylate de glycidyle, les acrylamides et notamment les méthacrylamides d'amino- éthyle, propyle, butyle, pentyle et hexyle, les cyanoacrylates, le polyéthylène glycol di-méthacrylate, l'acide acrylique, l'acide méthacrylique, le styrène, le parachloro-styrène, la N-vinyl pyrrolidone, la 4-vinyl pyridine, les halogénures de vinyle, le chlorure d'acryloyle, le chlorure de méthacryloyle, et de leur dérivés.

9. Procédé selon la revendication 1, dans lequel le premier matériau est disposé sur la surface sous la forme d'un film.

10. Procédé selon la revendication 9, dans lequel le premier matériau est disposé sur la surface par une technique choisie parmi la centrifugation, la pulvérisation, le trempage, l'électro-polymérisation, et l'électro-greffage.

11. Procédé selon la revendication 1, dans lequel le deuxième matériau est un matériau qui peut être électrodéposé.

12. Procédé selon la revendication 11, dans lequel le précurseur du deuxième matériau est un ion dudit matériau.

13. Procédé selon la revendication 12, dans lequel le deuxième matériau est un métal, et le précurseur dudit deuxième matériau est un ion de ce métal.

14. Procédé selon la revendication 13, dans lequel le précurseur du deuxième matériau est choisi dans le groupe constitué par les ions du cuivre, les ions du zinc, les ions de l'or, les ions de l'étain, du titane, du vanadium, du chrome, du fer, du cobalt, du lithium, du sodium, de l'aluminium, du magnésium, du potassium, du rubidium, du césium, du strontium, de l'yttrium, du niobium, du molybdène, du ruthénium, du rhodium, du palladium, de l'argent, du cadmium, de l'indium, du lutécium, de l'hafnium, du tantale, du tungstène, du rhénium, de l'osmium, de l'irridium, du platine, du mercure, du thalium, du plomb, du bismuth, des lanthanides et des actinides.

15. Procédé selon la revendication 1, dans lequel le deuxième matériau est un matériau qui peut être déposé par une technique choisie parmi une précipitation, une cristallisation, une réticulation et une agrégation.

16. Procédé selon la revendication 13, dans lequel le précurseur du deuxième matériau est un sel insoluble du deuxième matériau.

17. Procédé selon la revendication 1, dans lequel le précurseur du deuxième matériau est inséré au sein du premier matériau, disposé sur la surface, au moyen d'une solution d'insertion qui est à la fois un solvant du précurseur du deuxième matériau, et un solvant du premier matériau, ladite solution d'insertion comprenant le précurseur du deuxième matériau.

18. Procédé selon la revendication 1, dans lequel le précurseur du deuxième matériau est inséré au sein du premier matériau, disposé sur la surface, au moyen d'une solution d'insertion qui est à la fois un solvant ou un dispersant du précurseur du deuxième matériau, et une solution qui gonfle le premier matériau, ladite solution d'insertion comprenant ledit précurseur du deuxième matériau.

19. Procédé selon la revendication 1, dans lequel l'étape consistant à insérer le précurseur du deuxième matériau au sein du premier matériau disposé sur ladite surface est réalisée en même temps que l'étape consistant à disposer sur ladite surface le premier matériau au moyen d'une solution comprenant à la fois ledit premier matériau ou un précurseur dudit premier matériau, et le précuseur du deuxième matériau.

20. Procédé selon la revendication 17 ou la revendication 18, dans lequel la solution d'insertion est une solution aqueuse.

21. Procédé selon la revendication 1, dans lequel le précurseur du deuxième matériau est transformé en ledit premier matériau par une technique choisie parmi l'électrodéposition et la précipitation.

22. Procédé selon les revendications 5 et 13, dans lequel la surface est une surface conductrice ou semi-conductrice, le premier matériau est un polymère vinylique, le deuxième matériau est un métal, et le précurseur de ce métal est un ion de ce métal.

23. Procédé selon la revendication 1 pour un renforcement d'interface entre un substrat conducteur ou semi-conducteur et un métal.

24. Procédé selon la revendication 1 pour la fabrication d'un élément d'interconnection en microélectronique.

25. Procédé selon la revendication 1 pour le traitement anti-corrosion d'une surface métallique.

26. Procédé selon la revendication 1 pour le traitement de surface d'un objet implantable dans un organisme vivant.

27. Procédé selon la revendication 1 pour la fabrication d'une biopuce.

28. Procédé selon la revendication 1 pour la fabrication d'une surface ayant des propriétés catalytiques.

## Claims

1. Process for coating a surface with a first material and a second material, comprising the following steps:
- placing the first material on said surface,
- inserting into the first material a precursor of the second material, at the same time as or after the step consisting in placing said first material onto said surface,
- converting said precursor of the second material inserted into the first material into said second material such that this second material becomes formed on said surface to be coated and within said first material placed on said surface.

2. Process according to Claim 1, in which the surface is mineral or organic.

3. Process according to Claim 1, in which the first material is an organic material and the second material is a mineral material.

4. Process according to Claim 3, in which the first material is an organic macromolecule or a polymer and the second material is a mineral material.

5. Process according to Claim 1, in which the first material is obtained from a chemical precursor thereof chosen from the group consisting of vinyl monomers, functionalized or non-functionalized diazonium salts, functionalized or non-functionalized sulphonium salts, functionalized or non-functionalized phosphonium salts and functionalized or non-functionalized iodonium salts, and mixtures thereof.

6. Process according to Claim 5, in which the first material is obtained from one or more activated vinyl monomer(s), of structure (I) below: 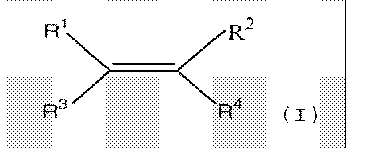 in which R¹, R², R³ and R⁴ are organic groups chosen, independently of each other, from the group consisting of the following organic functions: hydrogen, hydroxyl, amine, thiol, carboxylic acid, ester, amide, imide, imido-ester, acid halide, acid anhydride, nitrile, succinimide, phthalimide, isocyanate, epoxide, siloxane, benzoquinone, benzophenone, carbonyldiimidazole, para-toluenesulphonyl, para-nitrophenyl chloroformate, ethylenic, vinyl and aromatic.

7. Process according to Claim 6, in which at least one from among R¹, R², R³ and R⁴ is a functional group capable of complexing cations.

8. Process according to Claim 5, in which the first material is a polymer obtained by polymerization of a vinyl monomer chosen from the group consisting of vinyl monomers such as acrylonitrile, methacrylonitrile, methyl methacrylate, ethyl methacrylate, butyl methacrylate, propyl methacrylate, hydroxyethyl methacrylate, hydroxypropyl methacrylate, glycidyl methacrylate, acrylamides and especially aminoethyl, aminopropyl, aminobutyl, aminopentyl and aminohexyl methacrylamides, cyanoacrylates, polyethylene glycol dimethacrylate, acrylic acid, methacrylic acid, styrene, para-chlorostyrene, N-vinylpyrrolidone, 4-vinylpyridine, vinyl halides, acryloyl chloride and methacryloyl chloride, and derivatives thereof.

9. Process according to Claim 1, in which the first material is placed on the surface in the form of a film.

10. Process according to Claim 9, in which the first material is placed on the surface via a technique chosen from centrifugation, spraying, dipping, electropolymerization and electrografting.

11. Process according to Claim 1, in which the second material is a material that can be electrodeposited.

12. Process according to Claim 11, in which the precursor of the second material is an ion of said material.

13. Process according to Claim 12, in which the second material is a metal and the precursor of said second material is an ion of this metal.

14. Process according to Claim 13, in which the precursor of the second material is chosen from the group consisting of copper ions, zinc ions, gold ions, tin, titanium, vanadium, chromium, iron, cobalt, lithium, sodium, aluminium, magnesium, potassium, rubidium, caesium, strontium, yttrium, niobium, molybdenum, ruthenium, rhodium, palladium, silver, cadmium, indium, lutetium, hafnium, tantalum, tungsten, rhenium, osmium, iridium, platinum, mercury, thallium, lead, bismuth, lanthanide and actinide ions.

15. Process according to Claim 1, in which the second material is a material that can be deposited via a technique chosen from precipitation, crystallization, crosslinking and aggregation.

16. Process according to Claim 13, in which the precursor of the second material is an insoluble salt of the second material.

17. Process according to Claim 1, in which the precursor of the second material is inserted into the first material, placed on the surface, by means of an insertion solution that is both a solvent for the precursor of the second material, and a solvent for the first material, said insertion solution comprising the precursor of the second material.

18. Process according to Claim 1, in which the precursor of the second material is inserted into the first material, placed on the surface, using an insertion solution that is both a solvent or a dispersing agent for the precursor of the second material, and a solution that swells the first material, said insertion solution comprising said precursor of the second material.

19. Process according to Claim 1, in which the step consisting in inserting the precursor of the second material into the first material placed on said surface is performed at the same time as the step consisting in placing on said surface the first material using a solution comprising both said first material or a precursor of said first material, and the precursor of the second material.

20. Process according to Claim 17 or Claim 18, in which the insertion solution is an aqueous solution.

21. Process according to Claim 1, in which the precursor of the second material is converted into said first material via a technique chosen from electrodeposition and precipitation.

22. Process according to Claims 5 and 13, in which the surface is a conductive or semiconductive surface, the first material is a vinyl polymer, the second material is a metal and the precursor of this metal is an ion of this metal.

23. Process according to Claim 1, for an interface reinforcement between a conductive or semiconductive substrate and a metal.

24. Process according to Claim 1 for the manufacture of an interconnection component in microelectronics.

25. Process according to Claim 1 for the anticorrosion treatment of a metallic surface.

26. Process according to Claim 1 for the surface treatment of an object that can be implanted into a living organism.

27. Process according to Claim 1 for the manufacture of a biochip.

28. Process according to Claim 1 for the manufacture of a surface with catalytic properties.

## Patentansprüche

1. Verfahren zum Beschichten einer Oberfläche mit einem ersten Material und mit einem zweiten Material, wobei das Verfahren die folgenden Stufen umfasst:
- Anordnen des ersten Materials auf der genannten Oberfläche,
- Einführen eines Vorläufers für das zweite Material in das Innere des ersten Materials gleichzeitig mit oder nach der Stufe des Anordnens des ersten Materials auf der genannten Oberfläche und
- Umwandlung des Vorläufers für das zweite Material, der in das Innere des ersten Materials eingeführt worden ist, in das genannte zweite Material in der Weise, dass dieses zweite Material sich auf der zu beschichtenden genannten Oberfläche und im Innern des auf der genannten Oberfläche angeordneten ersten Materials bildet.

2. Verfahren nach Anspruch 1, bei dem die Oberfläche eine mineralische oder organische Oberfläche ist.

3. Verfahren nach Anspruch 1, bei dem das erste Material ein organisches Material ist und das zweite Material ein mineralisches Material ist.

4. Verfahren nach Anspruch 3, bei dem das erste Material ein organisches Makromolekül oder ein Polymer ist und das zweite Material ein mineralisches Material ist.

5. Verfahren nach Anspruch 1, bei dem das erste Material aus einem chemischen Vorläufer hergestellt worden ist, ausgewählt aus der Gruppe, die besteht aus Vinylmonomeren, funktionalisierten oder nicht funktionalisierten Diazoniumsalzen, funktionalisierten oder nicht funktionalisierten Sulfoniumsalzen, funktionalisierten oder nicht funktionalisierten Phosphoniumsalzen, funktionaüsierten oder nicht funktionalisierten lodoniumsalzen und Mischungen davon.

6. Verfahren nach Anspruch 5, bei dem das erste Material hergestellt worden ist aus einem oder mehreren aktiven Vinylmonomeren mit der folgenden Struktur (I): 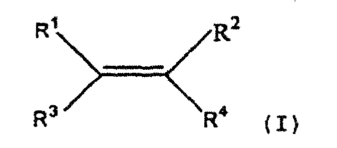 worin R¹, R², R³ und R⁴ organische Gruppen darstellen, die unabhängig voneinander ausgewählt werden aus der Gruppe, bestehend aus den folgenden organischen Funktionen: Wasserstoff-, Hydroxyl-, Amin-, Thiol-, Carbonsäure-, Ester-, Amid-, lmid-, Imidoester-, Säurehalogenid-, Säureanhydrid-, Nitril-, Succinimid-, Phthalimid-, Isocyanat-, Epoxid-, Siloxan-, Benzochinon-, Benzophenon-, Carbonyldümidazof-, p-Toluolsulfonyl-, p-Nitrophenylchlorformiat-, Ethylen-, Vinyl- und aromatischen Funktionen.

7. Verfahren nach Anspruch 6, bei dem mindestens einer der Reste R¹, R², R³ und R⁴ eine funktionelle Gruppe darstellt, die Kationen komplex binden kann.

8. Verfahren nach Anspruch 5, bei dem das erste Material ein Polymer ist, das hergestellt worden ist durch Polymerisation eines Vinylmonomers, ausgewählt aus der Gruppe, die besteht aus Vinyl-Monomeren wie Acrylnitril, Methacrylnitril, Methylmethacrylat, Ethylmethacrylat, Butylmethacrylat, Propylmethacrylat, Hydroxyethylmethacrylat, Hydroxypropylmethacrylat, Glycidylmethacrylat, Acrylamiden und insbesondere Amino-ethyl-, -propyl-, -butyl-, - pentyl- und -hexyl-methacrylamiden, Cyanoacrylaten, Polyethylenglycoldimethacrylat, Acrylsäure, Methacrylsäure, Styrol, p-Chlorstyrol, N-Vinylpyrrolidon, 4-Vinylpyridin, Vinylhalogeniden, Acryloylchlorid, Methacryloylchlorid und Derivaten davon.

9. Verfahren nach Anspruch 1, bei dem das erste Material in Form eines Films auf der Oberfläche abgeschieden wird.

10. Verfahren nach Anspruch 9, bei dem das erste Material unter Anwendung einer Methode, ausgewählt aus der Gruppe Zentrifugieren, Aufstäuben, lmprägnieren, Elektropolymerisation und Elektroaufpfropfen, auf die Oberfläche aufgebracht wird.

11. Verfahren nach Anspruch 1, bei dem das zweite Material ein Material darstellt, das durch Elektroabscheidung (Elektroplattierung) aufgebracht werden kann.

12. Verfahren nach Anspruch 11, bei dem der Vorläufer des zweiten Materials ein Ion des genannten Materials ist.

13. Verfahren nach Anspruch 12, bei dem das zweite Material ein Metall darstellt und der Vorläufer des zweiten Materials ein lon dieses Metalls darstellt.

14. Verfahren nach Anspruch 13, bei dem der Vorläufer des zweiten Materials ausgewählt wird aus der Gruppe, die besteht aus Kupferionen, Zinkionen, Goldionen, Zinnionen, Titanionen, Vanadinionen, Chromionen, Eisenionen, Kobaltionen, Lithiumionen, Natriumionen, Aluminiumionen, Magnesiumionen, Kaliumionen, Rubidiumionen, Cäsiumionen, Strontiumionen, Yttriumionen, Niobionen, Molybdänionen, Rutheniumionen, Rhodiumionen, Palladiumionen, Silberionen, Cadmiumionen, Indiumionen, Lutetiumionen, Hafnimionen, Tantalionen, Wolframionen, Rheniumionen, Osmiumionen, Iridiumionen, Platinionen, Quecksilberionen, Thalliumionen, Bleiionen, Wismutionen, Ionen von Lanthaniden und Actiniden.

15. Verfahren nach Anspruch 1, bei dem das zweite Material ein Material darstellt, das unter Anwendung einer Methode abgeschieden werden kann, die ausgewählt wird aus der Gruppe Präzipitation, Kristallisation, Vernetzung und Aggregation.

16. Verfahren nach Anspruch 13, bei dem der Vorläufer des zweiten Materials ein unlösliches Salz des zweiten Materials ist.

17. Verfahren nach Anspruch 1, bei dem der Vorläufer des zweiten Materials in das Innere des ersten Materials, das auf der Oberfläche angeordnet worden ist, eingeführt wird mittels einer Einführungslösung, die gleichzeitig ein Lösungsmittel für den Vorläufer des zweiten Materials und ein Lösungsmittel für das erste Material darstellt, wobei die genannte Einführungslösung den Vorläufer des zweiten Materials enthält.

18. Vorfahren nach Anspruch 1, bei dem der Vorläufer für das zweite Material in das Innere des auf der Oberfläche angeordneten ersten Materials eingeführt wird mittels einer Einführungslösung, die gleichzeitig ein Lösungsmittel oder ein Dispergiermittel für den Vorläufer des zweiten Materials und eine Lösung darstellt, die das erste Material zum Aufquellen bringt, wobei die genannte Einführungslösung den genannten Vorläufer für das zweite Material enthält.

19. Verfahren nach Anspruch 1, bei dem die Stufe zur Einführung des Vorläufers für das zweite Material in das Innere des auf der genannten Oberfläche angeordneten ersten Materials gleichzeitig mit der Stufe des Anordnens des ersten Materials auf der genannten Oberfläche mittels einer Lösung durchgeführt wird, die gleichzeitig das erste Material oder einen Vorläufer für das erste Material und den Vorläufer für das zweite Material enthält.

20. Verfahren nach Anspruch 17 oder 18, bei dem die Einführungslösung eine wässrige Lösung ist.

21. Verfahren nach Anspruch 1, bei dem der Vorläufer für das zweite Material unter Anwendung einer Methode in das genannte erste Material umgewandelt wird, die ausgewählt wird aus der Gruppe Elektroabscheidung (Elektroplattierung) und Präzipitation.

22. Verfahren nach den Ansprüchen 5 und 13, bei dem die Oberfläche eine elektrisch leitende oder halbleitende Oberfläche ist, das erste Material ein Vinylpolymer ist, das zweite Material ein Metall ist und der Vorläufer für dieses Metall ein lon dieses Metalls ist.

23. Verfahren nach Anspruch 1 zur Verstärkung der Grenzfläche zwischen einem elektrisch leitenden Substrat oder halbleitenden Substrat und einem Metall.

24. Verfahren nach Anspruch 1 zur Herstellung eines mikroelektronischen Verbindungselements.

25. Verbindung nach Anspruch 1 zur Antikorrosionsbehandlung einer Metalloberfläche.

26. Verfahren nach Anspruch 1 zur Behandlung der Oberfläche eines in einen lebenden Organismus implantierbaren Gegenstandes.

27. Verfahren nach Anspruch 1 zur Herstellung eines Biochips.

28. Verfahren nach Anspruch 1 zur Herstellung einer Oberfläche, die katalytische Eigenschaften aufweist.
